(19) Europäisches Patentamt
European Patent Office
Office européen des brevets

(11) EP 3 522 210 B1

(12) **EUROPEAN PATENT SPECIFICATION**

(45) Date of publication and mention of the grant of the patent:
**15.04.2020 Bulletin 2020/16**

(21) Application number: **17856357.3**

(22) Date of filing: **28.09.2017**

(51) Int Cl.:
***H01L 23/12*** *(2006.01)* ***H01L 21/312*** *(2006.01)*
***H01L 21/683*** *(2006.01)*

(86) International application number:
**PCT/JP2017/035287**

(87) International publication number:
**WO 2018/062408 (05.04.2018 Gazette 2018/14)**

(54) **LAMINATE AND METHOD OF MANUFACTURING SEMICONDUCTOR DEVICE**

LAMINAT UND VERFAHREN ZUR HERSTELLUNG EINER HALBLEITERVORRICHTUNG

STRATIFIÉ ET PROCÉDÉ DE FABRICATION D'UN DISPOSITIF SEMI-CONDUCTEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.09.2016 JP 2016194840**

(43) Date of publication of application:
**07.08.2019 Bulletin 2019/32**

(73) Proprietor: **FUJIFILM Corporation**
**Tokyo 106-8620 (JP)**

(72) Inventor: **FUKUHARA, Kei**
**Haibara-gun**
**Shizuoka 421-0396 (JP)**

(74) Representative: **Hoffmann Eitle**
**Patent- und Rechtsanwälte PartmbB**
**Arabellastraße 30**
**81925 München (DE)**

(56) References cited:
**WO-A1-2013/111241** **WO-A1-2013/111241**
**WO-A1-2015/137281** **CN-A- 105 225 965**
**JP-A- 2007 047 771** **JP-A- 2010 141 126**
**JP-A- 2010 141 126** **JP-A- 2016 079 340**
**US-A1- 2015 024 552**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 522 210 B1

## Description

## BACKGROUND OF THE INVENTION

1. Field of the Invention

The present invention relates to a laminate and a method of manufacturing a semiconductor device.

2. Description of the Related Art

In semiconductor package manufacturing steps, reduction in size and weight and high-density mounting on a substrate have been strongly required in recent years. A wafer level chip size package (WL-CSP) is ideal from the viewpoint of a reduction in size and weight since rewiring (RDL) on a semiconductor wafer, electrode formation, resin sealing, and dicing are performed thereon, and already, the wafer level chip size package has been employed in the semiconductor package manufacturing steps.

In general, manufacturing of WL-CSP has been performed through a so-called chip-first method as shown in Fig. 1. In the chip-first method, for example, in a state in which molded chips 3 are generally temporarily fixed to a surface of a support 1 on which a temporary adhesive film 2 is provided ((1) in Fig. 1), a resin film 4 is directly formed on surfaces of the chips 3 ((2) in Fig. 1). Next, the resin film 4 is exposed and developed to form grooves 5 ((3) in Fig. 1). Next, wires 6 are formed in the grooves 5 and a part of the resin film 4 ((4) in Fig. 1). A rewiring structure is formed by repeating formation of the resin film 4, exposure and development of the resin film 4, formation of the grooves 5 and formation of the wires 6 ((5) in Fig. 1).

JP2015-165015A discloses a polyimide resin composition which is used in manufacturing of a flexible device such as an element.

JP2016-086158A discloses a laminate for wafer processing which allows for easy temporary adhesion of a wafer and a support substrate, easy peeling of a processed wafer from the support substrate, and easy removal of bonding residue of the wafer after peeling.

## SUMMARY OF THE INVENTION

As shown in Fig. 1, in a case where the rewiring is formed by the chip-first method, the chips 3 placed on the temporary adhesive film 2 sink into the temporary adhesive film 2, and thus the yield is reduced in some cases.

Therefore, as shown in Fig. 2, an RDL-first method is also considered. For example, in the RDL-first method, first, a temporary adhesive film 2 is provided on a support 1, and a resin film 4 is formed on a surface of the temporary adhesive film ((1) in Fig. 2). Next, the resin film 4 is exposed and developed to form grooves 5 ((2) in Fig. 2). Next, wires 6 are provided in the grooves 5 and in a part of the resin pattern 4 obtained by exposing and developing the resin film. In general, formation of the resin film 4, exposure and development of the resin film 4, and formation of the wires 6 are performed once or a plurality of times, and then chips 3 are mounted to be connected to the wires 6 ((4) in Fig. 2).

However, in a case where a photosensitive resin composition containing a resin and a solvent is applied to the surface of the temporary adhesive film to form the resin film 4 on the surface of the temporary adhesive film 2, the temporary adhesive film is dissolved in or swollen by the solvent contained in the photosensitive resin composition, and thus the temporary adhesive film and the resin film are partially mixed in some cases. In a case where the temporary adhesive film and the resin film are mixed, it becomes difficult to separate the temporary adhesive film 2 subjected to desired processing from the resin pattern 4.

An object of the invention is to solve the above problems and to provide a laminate which includes a temporary adhesive film and a resin pattern and in which the temporary adhesive film and the resin pattern can be separated without being mixed with each other. Another object of the invention is to provide a method of manufacturing a semiconductor device using the laminate. This is achieved by a laminate according to claim 1 and by a manufacturing method for a laminate according to claim 10. Any embodiment not comprising all the features of one of claims 1 or 10 does not pertain to the invention.

The inventors have conducted intensive studies under such circumstances, and as a result, found that the temporary adhesive film and the resin pattern are hard to mix with each other with a configuration in which the resin pattern contains a surfactant.

According to the invention, it is possible to provide a laminate which includes a temporary adhesive film and a resin pattern and in which the temporary adhesive film and the resin pattern can be separated without being mixed with each other. It is also possible to provide a method of manufacturing a semiconductor device using the laminate.

## BRIEF DESCRIPTION OF THE DRAWINGS

Fig. 1 is a schematic view for a case in which rewiring is formed by a chip-first method.
Fig. 2 is a schematic view for a case in which rewiring is formed by an RDL-first method according to the invention.

## DESCRIPTION OF THE PREFERRED EMBODIMENTS

In the invention, the following description of constituent elements may be based on representative embodiments of the invention, but the invention is not limited to the embodiments.

Regarding the expression of a group (atomic group) in this specification, a group denoted with no expression of substitution or unsubstitution includes both a group having no substituent and a group having a substituent. For example, an "alkyl group" includes not only an alkyl group having no substituent (unsubstituted alkyl group), but also an alkyl group having a substituent (substituted alkyl group).

In this specification, "exposure" includes not only exposure using light, but also drawing using particle beams such as electron beams or ion beams, unless otherwise specified. Generally, examples of the light which is used for exposure include a bright line spectrum of a mercury lamp, far ultraviolet rays represented by excimer laser, actinic rays or radiation such as extreme ultraviolet rays (EUV light), X-rays, or electron beams.

In this specification, a numerical value range expressed by using "to" means a range including numerical values described before and after "to" as a lower limit value and an upper limit value.

In this specification, "(meth)acrylate" represents one or both of "acrylate" and "methacrylate", "(meth)acryl" represents one or both of "acryl" and "methacryl", and "(meth)acryloyl" represents one or both of "acryloyl" and "methacryloyl".

In this specification, the term "step" includes not only an independent step, but also a step in which a desired action of the step is achieved even in a case where the step cannot be clearly differentiated from other steps.

In this specification, a weight-average molecular weight (Mw) and a number-average molecular weight (Mn) are defined as values in terms of polystyrene according to gel permeation chromatography (GPC) measurement, unless otherwise specified. In this specification, the weight-average molecular weight (Mw) and the number-average molecular weight (Mn) can be measured using, for example, HLC-8220GPC (manufactured by Tosoh Corporation) with one or more of guard columns HZ-L, TSKgel Super HZM-M, TSKgel Super HZ4000, TSKgel Super HZ3000, and TSKgel Super HZ2000 (manufactured by Tosoh Corporation) as a column. Unless otherwise specified, tetrahydrofuran (THF) is used as an eluent for measurement. Unless otherwise specified, detection is made using a detector of an ultraviolet (UV) wavelength of 254 nm.

The shapes, sizes, numbers, positions, and the like illustrated in the drawings are optional, and the invention is not limited thereto.

Laminate

A laminate according to an embodiment of the invention includes a temporary adhesive film, a resin pattern which is positioned on a surface of the temporary adhesive film, and a metal which is positioned at least between the resin patterns, and the resin pattern contains a surfactant.

Due to such a configuration, in forming a resin film using a photosensitive resin composition containing a resin and a solvent on a surface of the temporary adhesive film, it is possible to suppress dissolving or swelling of the temporary adhesive film in or by the solvent contained in the photosensitive resin composition. Therefore, it is possible to effectively suppress mixing of the temporary adhesive film and the resin film. As a result, it is possible to provide a laminate in which the temporary adhesive film and the resin pattern can be separated without being mixed with each other.

The mechanism by which the effect is obtained is assumed as follows: by using a resin composition containing a surfactant, a hydrophobic group of the surfactant acts on the temporary adhesive film, a hydrophilic group acts on the resin pattern in forming a film formed of a photosensitive resin composition on the surface of the temporary adhesive film, and mixing or cissing at an interface between the temporary adhesive film and the film formed of the photosensitive resin composition can be suppressed.

Through such a laminate, it is possible to appropriately manufacture a semiconductor device even in an RDL-first method.

<Temporary Adhesive Film>

The temporary adhesive film used in the invention contains a resin. The temporary adhesive film preferably

further contains a release agent. In addition, the temporary adhesive film may further contain other components without departing from the gist of the invention. Details of the resin, release agent, and other components have the same meanings as those of the resin, release agent, and other components to be described in Composition for Temporary Adhesion to be described later.

The temporary adhesive film used in the invention is formed using a composition for temporary adhesion. The composition for temporary adhesion preferably contains a temporary adhesive film forming component such as a resin and a release agent, and a solvent.

In the invention, the thickness of the temporary adhesive film is preferably 20 to 200 $\mu$m, and more preferably 30 to 100 $\mu$m.

In the invention, the temporary adhesive film is generally positioned on a support. The support is not particularly specified as long as it supports the temporary adhesive film, and examples thereof include a silicon substrate (such as a silicon wafer), a glass substrate, and a metal substrate. The support is preferably a silicon substrate which is representatively used as a substrate of a semiconductor device. The thickness of the support is, for example, in the range of 300 $\mu$m to 5 mm, but is not particularly limited.

The temporary adhesive film may be provided on a surface of the support, or may be provided via some layers.

<<Composition for Temporary Adhesion>>

The composition for temporary adhesion used in the invention preferably contains a temporary adhesive film forming component and a solvent. As the temporary adhesive film forming component, at least a resin is preferably contained, and a release agent is preferably further contained.

<<<Resin>>>

The composition for temporary adhesion used in the invention contains at least one type of resin. In the invention, the type of the resin is not particularly specified as long as various characteristics of the temporary adhesive film can be achieved, and at least one of a thermoplastic resin, a thermosetting resin, or a photocurable resin is preferably contained.

Examples of the resin include block copolymers, random copolymers, and graft copolymers, and block copolymers are preferable. In a case where the resin is a block copolymer, the flow of the composition for temporary adhesion in the heating process can be suppressed. Accordingly, it is possible to maintain the adhesion even in the heating process, and it is possible to expect that the peelability does not change even after the heating process.

The type of the resin is not particularly limited, and styrene-based resins (particularly, polystyrene-based copolymers), polyester-based copolymers, polyolefin-based copolymers, polyurethane-based copolymers, polyamide-based copolymers, polyacrylic copolymers, silicone-based copolymers, polyimide-based copolymers, cycloolefin-based polymers, and the like can be used.

In the invention, the resin is preferably at least one type of thermoplastic resin selected from a styrene-butadiene-styrene block copolymer (SBS), a styrene-isoprene-styrene block copolymer (SIS), a polystyrene-poly(ethylene-propylene)diblock copolymer, a polystyrene-poly(ethylene-propylene)-polystyrene triblock copolymer (SEPS), a polystyrene-poly(ethylene-butylene)-polystyrene triblock copolymer (SEBS), a polystyrene-poly(ethylene/ethylene-propylene)-polystyrene triblock copolymer (SEEPS), a cycloolefin-based polymer, and a thermoplastic polyimide resin, and more preferably at least one type of polystyrene-based elastomer selected from a polystyrene-poly(ethylene-propylene)diblock copolymer, a polystyrene-poly(ethylene-propylene)-polystyrene triblock copolymer (SEPS), a polystyrene-poly(ethylene-butylene)-polystyrene triblock copolymer (SEBS), and a polystyrene-poly(ethylene/ethylene-propylene)-polystyrene triblock copolymer (SEEPS).

Among these, the resin is preferably a block copolymer of styrene and other monomers, and is particularly preferably a styrene block copolymer having a styrene block at one or both terminals.

The resin is preferably a hydrogenated block copolymer. In a case where the resin is a hydrogenated product, heat stability and storage stability are improved. The hydrogenated product means a polymer having a structure in which a block copolymer is hydrogenated.

In the invention, the weight-average molecular weight of the elastomer is preferably 2,000 to 200,000, more preferably 10,000 to 200,000, and even more preferably 50,000 to 100,000.

In the invention, the elastomer is not particularly limited, and elastomers (polystyrene-based elastomers) containing a repeating unit derived from styrene, polyester-based elastomers, polyolefin-based elastomers, polyurethane-based elastomers, polyamide-based elastomers, polyacrylic elastomers, silicone-based elastomers, polyimide-based elastomers, and the like can be used. Particularly, polystyrene-based elastomers, polyester-based elastomers, and polyamide-based elastomers are preferable, and polystyrene-based elastomers are more preferable from the viewpoint of heat resistance and peelability.

In the invention, the elastomer is preferably a hydrogenated product. The elastomer is particularly preferably a hydrogenated polystyrene-based elastomer. In a case where the elastomer is a hydrogenated product, heat stability and storage stability are improved. In a case where a hydrogenated polystyrene-based elastomer is used, the above-described effect is remarkably exhibited. The hydrogenated product means a polymer having a structure in which an elastomer is hydrogenated.

In the invention, in a case where the temperature is increased from 25°C at a rate of temperature increase of 20°C/min, the 5% thermal mass reduction temperature of the elastomer is preferably 250°C or higher, more preferably 300°C or higher, even more preferably 350°C or higher, and still more preferably 400°C or higher. The upper limit value is not particularly limited, and preferably, for example, 1,000°C or lower, and more preferably 800°C or lower. According to this embodiment, a temporary adhesive film having excellent heat resistance is easily formed.

In the invention, the elastomer can be deformed up to 200% with a small external force at room temperature (20°C) in a case where the original size thereof is 100%. In addition, the elastomer preferably returns to 130% or less in a short period of time in a case where the external force is removed.

The polystyrene-based elastomer is not particularly limited, and can be appropriately selected according to the purpose. The polystyrene-based elastomer is preferably at least one type of polystyrene-based elastomer selected from a styrene-butadiene-styrene block copolymer (SBS), a styrene-isoprene-styrene block copolymer (SIS), a polystyrene-poly(ethylene-propylene)diblock copolymer (SEP), a polystyrene-poly(ethylene-propylene)-polystyrene triblock copolymer (SEPS), a polystyrene-poly(ethylene-butylene)-polystyrene triblock copolymer (SEBS), and a polystyrene-poly(ethylene/ethylene-propylene)-polystyrene triblock copolymer (SEEPS).

The proportion of a styrene-derived repeating unit in the polystyrene-based elastomer is preferably 90 mass% or less, more preferably 55 mass% or less, even more preferably 48 mass% or less, still more preferably 35 mass% or less, and yet still more preferably 33 mass% or less. The lower limit of the proportion of the styrene-derived repeating unit may be 0 mass%, but can also be set to 10 mass% or greater. Within such a range, warpage of the laminate can be more effectively suppressed.

The method of calculating the proportion of the styrene-derived repeating unit is performed according to a method described in examples to be described later.

In the invention, as an embodiment of the polystyrene-based elastomer, a combination of an elastomer A containing a styrene-derived repeating unit in a proportion of 10 mass% to 55 mass% in all repeating units and an elastomer B containing a styrene-derived repeating unit in a proportion of greater than 55 mass% and 95 mass% or less in all repeating units can be used. The occurrence of warpage can be effectively suppressed by using the elastomer A and the elastomer B in combination. The mechanism by which the effect is obtained can be assumed as follows. That is, since the elastomer A is a relatively soft material, a temporary adhesive film having elasticity is easily formed.

In addition, since the elastomer B is a relatively hard material, a temporary adhesive film having excellent peelability can be manufactured in a case where the elastomer B is contained.

The mass ratio between the elastomer A and the elastomer B in a case where the elastomers are mixed is preferably 1:99 to 99:1, more preferably 3:97 to 97:3, even more preferably 5:95 to 95:5, and still more preferably 10:90 to 90:10 (elastomer A:elastomer B). Within the above range, the above-described effect can be more effectively obtained.

The polystyrene-based elastomer is preferably a block copolymer of styrene and other monomers, more preferably a block copolymer having a styrene block at one or both terminals, and particularly preferably a block copolymer having a styrene block at both terminals. In a case where the polystyrene-based elastomer has a styrene block (styrene-derived repeating unit) at both ends, the heat resistance is likely to be further improved. This is because the styrene-derived repeating unit having high heat resistance is present at the terminal. Particularly, the block portion of the styrene-derived repeating unit is preferably a reactive polystyrene-based hard block since the heat resistance and the chemical resistance are likely to be further improved. In addition, such an elastomer is more preferable from the viewpoint of solubility in a solvent and resistance to a resist solvent.

In addition, in a case where the polystyrene-based elastomer is hydrogenated, the stability to heat is improved, and alteration such as decomposition and polymerization hardly occurs. Such a hydrogenated polystyrene-based elastomer is more preferable from the viewpoint of solubility in a solvent and resistance to a resist solvent.

From the viewpoint of peelability, the amount of unsaturated double bonds in the polystyrene-based elastomer is preferably less than 15 mmol, more preferably less than 5 mmol, and most preferably less than 0.5 mmol per gram of the polystyrene-based elastomer. The amount of unsaturated double bonds mentioned herein does not include the amount of unsaturated double bonds in a styrene-derived benzene ring. The amount of unsaturated double bonds can be calculated by nuclear magnetic resonance (NMR) measurement.

In this specification, the "styrene-derived repeating unit" is a styrene-derived structural unit contained in a polymer in the polymerization of styrene or a styrene derivative, and may have a substituent. Examples of the styrene derivative include $\alpha$-methylstyrene, 3-methylstyrene, 4-propylstyrene, and 4-cyclohexylstyrene. Examples of the substituent include an alkyl group having 1 to 5 carbon atoms, an alkoxy group having 1 to 5 carbon atoms, an alkoxyalkyl group having 1 to 5 carbon atoms, an acetoxy group, and a carboxyl group.

Examples of commercially available polystyrene-based elastomers include TUFPRENE A, TUFPRENE 125, TUFPRENE 126S, SOLPRENE T, ASAPRENE T-411, ASAPRENE T-432, ASAPRENE T-437, ASAPRENE T-438, ASAPRENE T-439, TUFTEC H1272, TUFTEC P1500, TUFTEC H1052, TUFTEC H1062, TUFTEC M1943, TUFTEC M1911, TUFTEC H1041, TUFTEC MP10, TUFTEC M1913, TUFTEC H1051, TUFTEC H1053, TUFTEC P2000, and TUFTEC H1043 (all manufactured by Asahi Kasei Corporation), ELASTOMER AR-850C, ELASTOMER AR-815C, ELASTOMER AR-840C, ELASTOMER AR-830C, ELASTOMER AR-860C, ELASTOMER AR-875C, ELASTOMER AR-885C, ELASTOMER AR-SC-15, ELASTOMER AR-SC-0, ELASTOMER AR-SC-5, ELASTOMER AR-710, ELASTOMER AR-SC-65, ELASTOMER AR-SC-30, ELASTOMER AR-SC-75, ELASTOMER AR-SC-45, ELASTOMER AR-720, ELASTOMER AR-741, ELASTOMER AR-731, ELASTOMER AR-750, ELASTOMER AR-760, ELASTOMER AR-770, ELASTOMER AR-781, ELASTOMER AR-791, ELASTOMER AR-FL-75N, ELASTOMER AR-FL-85N, ELASTOMER AR-FL-60N, ELASTOMER AR-1050, ELASTOMER AR-1060, ELASTOMER AR-1040 (all manufactured by ARONKASEI CO., LTD.), KRATON D1111, KRATON D1113, KRATON D1114, KRATON D1117, KRATON D1119, KRATON D1124, KRATON D1126, KRATON D1161, KRATON D1162, KRATON D1163, KRATON D1164, KRATON D1165, KRATON D1183, KRATON D1193, KRATON DX406, KRATON D4141, KRATON D4150, KRATON D4153, KRATON D4158, KRATON D4270, KRATON D4271, KRATON D4433, KRATON D1170, KRATON D1171, KRATON D1173, CALIFLEX IR 0307, CALIFLEX IR 0310, CALIFLEX IR 0401, KRATON D0242, KRATON D1101, KRATON D1102, KRATON D1116, KRATON D1118, KRATON D1133, KRATON D1152, KRATON D1153, KRATON D1155, KRATON D1184, KRATON D1186, KRATON D1189, KRATON D1191, KRATON D1192, KRATON DX405, KRATON DX408, KRATON DX410, KRATON DX414, KRATON DX415, KRATON A1535, KRATON A1536, KRATON FG1901, KRATON FG1924, KRATON G1640, KRATON G1641, KRATON G1642, KRATON G1643, KRATON G1645, KRATON G1633, KRATON G1650, KRATON G1651, KRATON G1652 (G1652MU-1000), KRATON G1654, KRATON G1657, KRATON G1660, KRATON G1726, KRATON G1701, KRATON G1702, KRATON G1730, KRATON G1750, KRATON G1765, KRATON G4609, and KRATON G4610 (all manufactured by Kraton Corporation), TR2000, TR2001, TR2003, TR2250, TR2500, TR2601, TR2630, TR2787, TR2827, TR1086, TR1600, SIS5002, SIS5200, SIS5250, SIS5405, SIS5505, DYNARON 6100P, DYNARON 4600P, DYNARON 6200P, DYNARON 4630P, DYNARON 8601P, DYNARON 8630P, DYNARON 8600P, DYNARON 8903P, DYNARON 6201B, DYNARON 1321P, DYNARON 1320P, DYNARON 2324P, and DYNARON 9901P (all manufactured by JSR Corporation), Denka STR series (manufactured by Denka Company Ltd.), QUINTAC 3520, QUINTAC 3433N, QUINTAC 3421, QUINTAC 3620, QUINTAC 3450, and QUINTAC 3460 (all manufactured by ZEON CORPORATION), TPE-SB series (manufactured by Sumitomo Chemical Co., Ltd.), RABALON series (manufactured by Mitsubishi Chemical Corporation), SEPTON 1001, SEPTON 1020, SEPTON 2002, SEPTON 2004, SEPTON 2005, SEPTON 2006, SEPTON 2007, SEPTON 2063, SEPTON 2104, SEPTON 4033, SEPTON 4044, SEPTON 4055, SEPTON 4077, SEPTON 4099, SEPTON HG252, SEPTON 8004, SEPTON 8006, SEPTON 8007, SEPTON 8076, SEPTON 8104, SEPTON V9461, SEPTON V9475, SEPTON V9827, HYBRAR 7311, HYBRAR 7125, HYBRAR 5127, and HYBRAR 5125 (all manufactured by KURARAY CO., LTD.), SUMIFLEX (manufactured by Sumitomo Bakelite Co., Ltd.), and LEOSTMER and ACTYMER (all manufactured by RIKEN TECHNOS CORPORATION).

In the invention, elastomers described in paragraphs 0050 to 0059, 0107, and 0108 in WO2015/190477A can also be used, and the contents thereof are incorporated herein.

In the invention, the resin is preferably contained in a proportion of 50.00 to 99.99 mass%, more preferably 70.00 to 99.99 mass%, and particularly preferably 88.00 to 99.99 mass% in the temporary adhesive film forming component in the composition for temporary adhesion, that is, in the temporary adhesive film. In a case where the resin content is within the above range, excellent adhesiveness and peelability are obtained.

In a case where an elastomer is used as the resin, the elastomer is preferably contained in a proportion of 50.00 to 99.99 mass%, more preferably 70.00 to 99.99 mass%, and particularly preferably 88.00 to 99.99 mass% in the temporary adhesive film forming component in the composition for temporary adhesion, that is, in the temporary adhesive film. In a case where the elastomer content is within the above range, excellent adhesiveness and peelability are obtained. In a case where two or more types of elastomers are used, the total content is preferably within the above range.

In a case where an elastomer is used as the resin, the elastomer content in the total resin mass is preferably 50 to 100 mass%, more preferably 70 to 100 mass%, even more preferably 80 to 100 mass%, and still more preferably 90 to 100 mass%. The resin may be substantially formed of an elastomer only. Regarding the fact that the resin is substantially formed of an elastomer only, the elastomer content in the total resin mass is preferably 99 mass% or greater, and more preferably 99.9 mass% or greater, and even more preferably, the resin is formed of an elastomer only.

<<<Release Agent>>>

The composition for temporary adhesion used in the invention preferably contains a release agent. In a case where a release agent is contained, peeling from the resin pattern can be made easier.

Examples of the release agent include a compound containing a fluorine atom and a compound containing a silicon atom. A compound containing a silicon atom is preferable, and a silicone compound is more preferable.

Examples of the silicone compound include a compound containing a Si-O bond. Examples thereof include a polyether-modified silicone, a silane coupling agent, a silicone resin, a silicone rubber, and a cyclic siloxane, and a polyether-modified silicone is preferable.

The refractive index of the silicone compound is preferably 1.350 to 1.480, more preferably 1.390 to 1.440, and even more preferably 1.400 to 1.430.

The weight reduction ratio of the silicone compound in a case where the silicone compound is heated for 30 minutes at 280°C under a $N_2$ gas flow is preferably 0% to 70%, more preferably 5% to 50%, and even more preferably 10% to 30%.

In the polyether-modified silicone used in the invention, the ratio represented by Formula (A) is preferably 80% or greater.

$$\text{Formula (A)} \qquad \{(MO+EO)/AO\}\times 100$$

In Formula (A), MO represents the mole percentage of a methylene oxide contained in the polyether structure in the polyether-modified silicone, EO represents the mole percentage of an ethylene oxide contained in the polyether structure in the polyether-modified silicone, and AO represents the mole percentage of an alkylene oxide contained in the polyether structure in the polyether-modified silicone.

The ratio represented by Formula (A) is preferably 90% or greater, more preferably 95% or greater, even more preferably 98% or greater, still more preferably 99% or greater, and yet still more preferably 100%.

The weight-average molecular weight of the polyether-modified silicone is preferably 500 to 100,000, more preferably 1,000 to 50,000, and even more preferably 2,000 to 40,000.

In the invention, the mass reduction ratio of the polyether-modified silicone in a case where the polyether-modified silicone is heated at a rate of temperature increase of 20°C/min from 20°C to 280°C under a nitrogen gas flow of 60 mL/min and kept for 30 minutes at a temperature of 280°C is preferably 50 mass% or less. Using such a compound, the surface state after processing of the support accompanying the heating is likely to be further improved. The mass reduction ratio of the polyether-modified silicone is preferably 45 mass% or less, more preferably 40 mass% or less, even more preferably 35 mass% or less, and still more preferably 30 mass% or less. The lower limit value of the mass reduction ratio of the polyether-modified silicone may be 0 mass%, but even in a case where the lower limit value is 15 mass% or greater, and further 20 mass% or greater, it is a sufficiently practicable level.

In the invention, the optical refractive index of the polyether-modified silicone is preferably 1.440 or less. The lower limit value is not particularly specified, but even in a case where the lower limit value is 1.400 or greater, it is a sufficiently practicable level.

The polyether-modified silicone used in the invention is preferably a polyether-modified silicone represented by any one of Formula (101), Formula (102), Formula (103), or Formula (104).

Formula (101)

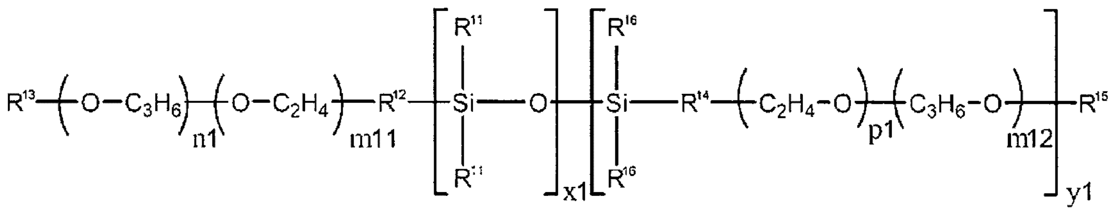

In Formula (101), $R^{11}$ and $R^{16}$ each independently represent a substituent, $R^{12}$ and $R^{14}$ each independently represent a divalent linking group, $R^{13}$ and $R^{15}$ represent a hydrogen atom or an alkyl group having 1 to 5 carbon atoms, $m^{11}$, $m^{12}$, n1, and p1 each independently represent a number of 0 to 20, and x1 and y1 each independently represent a number of 2 to 100.

Formula (102)

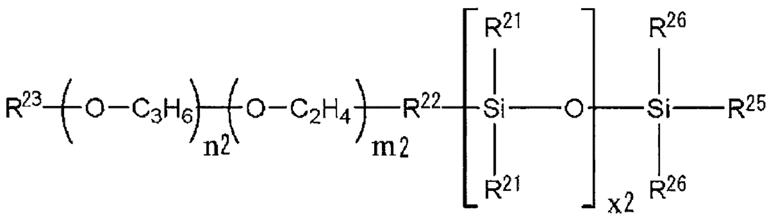

In Formula (102), $R^{21}$, $R^{25}$, and $R^{26}$ each independently represent a substituent, $R^{22}$ represents a divalent linking group, $R^{23}$ represents a hydrogen atom or an alkyl group having 1 to 5 carbon atoms, m2 and n2 each independently represent a number of 0 to 20, and x2 represents a number of 2 to 100.

Formula (103)

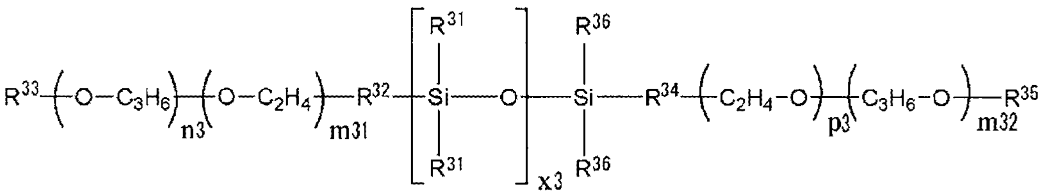

In Formula (103), $R^{31}$ and $R^{36}$ each independently represent a substituent, $R^{32}$ and $R^{34}$ each independently represent a divalent linking group, $R^{33}$ and $R^{35}$ represent a hydrogen atom or an alkyl group having 1 to 5 carbon atoms, m31, m32, n3, and p3 each independently represent a number of 0 to 20, and x3 represents a number of 2 to 100.

Formula (104)

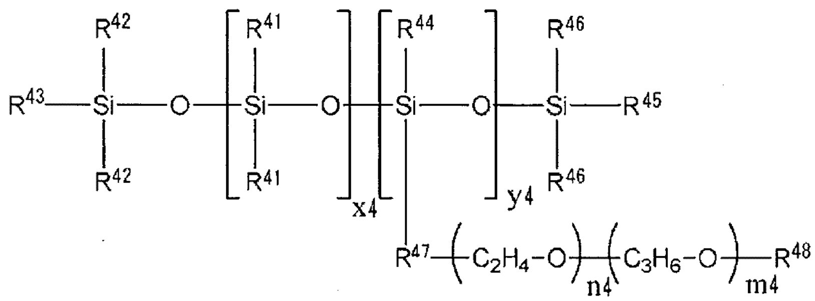

In Formula (104), $R^{41}$, $R^{42}$, $R^{43}$, $R^{44}$, $R^{45}$, and $R^{46}$ each independently represent a substituent, $R^{47}$ represents a divalent linking group, $R^{48}$ represents a hydrogen atom or an alkyl group having 1 to 5 carbon atoms, m4 and n4 each independently represent a number of 0 to 20, and x4 and y4 each independently represent a number of 2 to 100.

In Formula (101), $R^{11}$ and $R^{16}$ each independently represent a substituent, preferably an alkyl group having 1 to 5 carbon atoms or a phenyl group, and more preferably a methyl group.

In Formula (101), $R^{12}$ and $R^{14}$ each independently represent a divalent linking group, preferably a carbonyl group, an oxygen atom, an alkylene group having 1 to 6 carbon atoms, a cycloalkylene group having 6 to 16 carbon atoms, an alkenylene group having 2 to 8 carbon atoms, an alkynylene group having 2 to 5 carbon atoms, or an arylene group having 6 to 10 carbon atoms, and more preferably an oxygen atom.

In Formula (101), $R^{13}$ and $R^{15}$ are a hydrogen atom or an alkyl group having 1 to 5 carbon atoms, preferably a hydrogen atom or an alkyl group having 1 to 4 carbon atoms, and more preferably a hydrogen atom or an alkyl group having 1 to 3 carbon atoms.

In Formula (102), $R^{21}$, $R^{25}$, and $R^{26}$ each independently represent a substituent, and have the same meanings as those of $R^{11}$ and $R^{16}$ in Formula (101). Furthermore, the preferable ranges thereof are the same as those of $R^{11}$ and $R^{16}$.

In Formula (102), $R^{22}$ represents a divalent linking group, and has the same meaning as that of $R^{12}$ in Formula (101). Furthermore, the preferable ranges thereof are the same as those of $R^{12}$.

In Formula (102), $R^{23}$ represents a hydrogen atom or an alkyl group having 1 to 5 carbon atoms, and has the same meaning as those of $R^{13}$ and $R^{15}$ in Formula (101). Furthermore, the preferable ranges thereof are the same as

those of $R^{13}$ and $R^{15}$.

In Formula (103), $R^{31}$ and $R^{36}$ each independently represent a substituent, and have the same meanings as those of $R^{11}$ and $R^{16}$ in Formula (101). Furthermore, the preferable ranges thereof are the same as those of $R^{11}$ and $R^{16}$.

In Formula (103), $R^{32}$ and $R^{34}$ each independently represent a divalent linking group, and have the same meanings as that of $R^{12}$ in Formula (101). Furthermore, the preferable ranges thereof are the same as those of $R^{12}$.

In Formula (103), $R^{33}$ and $R^{35}$ each independently represent a hydrogen atom or an alkyl group having 1 to 5 carbon atoms, and have the same meanings as those of $R^{13}$ and $R^{15}$ in Formula (101). Furthermore, the preferable ranges thereof are the same as those of $R^{13}$ and $R^{15}$.

In Formula (104), $R^{41}$, $R^{42}$, $R^{43}$, $R^{44}$, $R^{45}$, and $R^{46}$ each independently represent a substituent, and have the same meanings as those of $R^{11}$ and $R^{16}$ in Formula (101). Furthermore, the preferable ranges thereof are the same as those of $R^{11}$ and $R^{16}$.

In Formula (104), $R^{47}$ represents a divalent linking group, and has the same meaning as that of $R^{12}$ in Formula (101). Furthermore, the preferable ranges thereof are the same as those of $R^{12}$.

In Formula (104), $R^{48}$ represents a hydrogen atom or an alkyl group having 1 to 5 carbon atoms, and has the same meaning as those of $R^{13}$ and $R^{15}$ in Formula (101). Furthermore, the preferable ranges thereof are the same as those of $R^{13}$ and $R^{15}$.

In Formulae (101) to (104), Formula (103) or Formula (104) is preferable, and Formula (104) is more preferable.

In the polyether-modified silicone used in the invention, the content of a polyoxyalkylene group in the molecule is not particularly limited, and it is desirable that the content of a polyoxyalkylene group is greater than 1 mass% in the total molecular weight.

The content of a polyoxyalkylene group is defined as "{(formula weight of polyoxyalkylene group in one molecule)/ {molecular weight of one molecule}$\times$100".

Examples of the silane coupling agent include a fluorine atom-containing silane coupling agent, and preferable examples thereof include chlorodimethyl[3-(2,3,4,5,6-pentafluorophenyl)propyl]silane, pentafluorophenyldimethylchlorosilane, pentafluorophenylethoxydimethylsilane, pentafluorophenylethoxydimethylsilane, trichloro(1H,1H,2H,2H-tridecafluoro-n-octyl)silane, trichloro(1H,1H,2H,2H-heptadecafluorodecyl)silane, trimethoxy(3,3,3-trifluoropropyl)silane, triethoxy(1H,1H,2H,2H-nonafluorohexyl)silane, triethoxy-1H,1H,2H,2H-heptadecafluorodecylsilane, trimethoxy(1H,1H,2H,2H-heptadecafluorodecyl)silane, trimethoxy(1H,1H,2H,2H-nonafluorohexyl)silane, trichloro[3-(pentafluorophenyl)propyl]silane, trimethoxy(11-pentafluorophenoxyundecyl)silane, triethoxy[5,5,6,6,7,7,7-heptafluoro-4,4-bis(trifluoromethyl)heptyl]silane, and trimethoxy(pentafluorophenyl)silane.

Examples of the release agent which can be used in the invention also include compounds which can be used as a release agent described in JP1987-036663A (JP-S62-036663A), JP1986-226746A (JP-S61-226746A), JP-1986-226745A (JP-S61-226745A), JP1987-170950A (JP-S62-170950A), JP1988-034540A (JP-S63-034540A), JP1995-230165A (JP-H07-230165A), JP1996-062834A (JP-H08-062834A), JP1997-054432A (JP-H09-054432A), JP1997-005988A (JP-H09-005988), or JP2001-330953A.

A commercially available product can also be used as the silicone compound used in the invention.

Examples thereof include ADVALON FA33, FLUID L03, FLUID L033, FLUID L051, FLUID L053, FLUID L060, FLUID L066, IM22, and WACKER-Belsil DMC 6038 (all manufactured by wacker asahikasei silicone co., ltd.), KF-352A, KF-353, KF-615A, KP-112, KP-341, X-22-4515, KF-354L, KF-355A, KF-6004, KF-6011, KF-6011P, KF-6012, KF-6013, KF-6015, KF-6016, KF-6017, KF-6017P, KF-6020, KF-6028, KF-6028P, KF-6038, KF-6043, KF-6048, KF-6123, KF-6204, KF-640, KF-642, KF-643, KF-644, KF-945, KP-110, KP-355, KP-369, KS-604, Polon SR-Conc, X-22-4272, and X-22-4952 (all manufactured by Shin-Etsu Chemical Co., Ltd.), 8526 ADDITIVE, FZ-2203, FZ-5609, L-7001, SF 8410, 2501 COSMETIC WAX, 5200 FORMULATION AID, 57 ADDITIVE, 8019 ADDITIVE, 8029 ADDITIVE, 8054 ADDITIVE, BY16-036, BY16-201, ES-5612 FORMULATION AID, FZ-2104, FZ-2108, FZ-2123, FZ-2162, FZ-2164, FZ-2191, FZ-2207, FZ-2208, FZ-2222, FZ-7001, FZ-77, L-7002, L-7604, SF8427, SF8428, SH 28 PAINR ADDITIVE, SH3749, SH3773M, SH8400, and SH8700 (all manufactured by Dow Chemical Company), BYK-378, BYK-302, BYK-307, BYK-331, BYK-345, BYK-B, BYK-347, BYK-348, BYK-349, and BYK-377 (all manufactured by BYK Additives & Instruments), and Silwet L-7001, Silwet L-7002, Silwet L-720, Silwet L-7200, Silwet L-7210, Silwet L-7220, Silwet L-7230, Silwet L-7605, TSF4445, TSF4446, TSF4452, Silwet Hydrostable 68, Silwet L-722, Silwet L-7280, Silwet L-7500, Silwet L-7550, Silwet L-7600, Silwet L-7602, Silwet L-7604, Silwet L-7607, Silwet L-7608, Silwet L-7622, Silwet L-7650, Silwet L-7657, Silwet L-77, Silwet L-8500, Silwet L-8610, TSF4440, TSF4441, TSF4450, and TSF4460 (all manufactured by Momentive Performance Materials Inc.).

As commercially available products thereof, "BYK-300", "BYK-306", "BYK-310", "BYK-315", "BYK-313", "BYK-320", "BYK-322", "BYK-323", "BYK-325", "BYK-330", "BYK-333", "BYK-337", "BYK-341", "BYK-344", "BYK-370", "BYK-375", "BYK-UV3500", "BYK-UV3510", "BYK-UV3570", "BYK-3550", "BYK-SILCLEAN3700", and "BYK-SILCLEAN3720" (trade names) (all manufactured by BYK Additives & Instruments), "AC FS 180", "AC FS 360", and "AC S 20" (trade names) (all manufactured by Algin-Chemie), "POLYFLOW KL-400X", "POLYFLOW KL-400HF", "POLYFLOW KL-401", "POLYFLOW KL-402", "POLYFLOW KL-403", "POLYFLOW KL-404", "POLYFLOW KL-700" " (trade names) (all manufactured by KYOEISHA CHEMICAL Co., LTD.), "KP-301", "KP-306", "KP-109", "KP-310", "KP-310B", "KP-323", "KP-326", "KP-341", "KP-104", "KP-110", "KP-112", "KP-360A", "KP-361", "KP-354", "KP-357", "KP-358", "KP-359", "KP-362", "KP-365", "KP-366", "KP-368", "KP-330", "KP-650", "KP-651", "KP-390", "KP-391", and "KP-392" (trade names) (all manufactured by Shin-Etsu Chemical Co., Ltd.), "LP-7001", "LP-7002", "8032 ADDITIVE", "FZ-2110", "FZ-2105", "67 ADDITIVE", "8618 ADDITIVE", "3 ADDITIVE", and "56 ADDITIVE" (trade names) (all manufactured by Dow Chemical Company), "TEGO WET 270" (manufactured by Evonik Japan), and "NBX-15" (manufactured by NEOS COMPANY LIMITED) can also be used.

Examples of the fluorine atom-containing compound include fluorine-based liquid compounds. Regarding the fluorine-based liquid compounds, paragraphs 0025 to 0035 in WO2015/190477A can be referred to, and the contents thereof are incorporated herein. Examples of commercially available products thereof include fluorine-based liquid compounds among MEGAFACE series manufactured by DIC Corporation, such as MEGAFACE F-557.

In a case where a release agent is used, the content thereof is preferably within a range of 0.001 to 1.0 mass% of the temporary adhesive film forming component, that is, the composition for temporary adhesion. Only one type of release agent, or two or more types of release agents may be contained. In a case where two or more types are contained, the total content thereof is preferably within the above range.

Particularly, in a case where a silicone compound is used, the content thereof is preferably 0.001 to 1.0 mass% of the temporary adhesive film forming component, that is, the composition for temporary adhesion. The lower limit of the silicone compound content is more preferably 0.004 mass% or greater, even more preferably 0.006 mass% or greater, still more preferably 0.008 mass% or greater, and yet still more preferably 0.009 mass% or greater. The upper limit of the silicone compound content is preferably 0.8 mass% or less, more preferably 0.6 mass% or less, even more preferably 0.3 mass% or less, still more preferably 0.15 mass% or less, and yet still more preferably 0.09 mass% or less.

The composition for temporary adhesion used in the invention may contain only one type of silicone compound, or two or more types of silicone compounds. In a case where two or more types are contained, the total content thereof is preferably within the above range.

<<<Solvent>>>

The composition for temporary adhesion used in the invention preferably contains a solvent. As the solvent, a known solvent can be used without limitation, and an organic solvent is preferable.

Suitable examples of the organic solvent include esters such as ethyl acetate, n-butyl acetate, isobutyl acetate, amyl formate, isoamyl acetate, butyl propionate, isopropyl butyrate, ethyl butyrate, butyl butyrate, methyl lactate, ethyl lactate, alkyl alkyloxyacetate (example: methyl alkyloxyacetate, ethyl alkyloxyacetate, and butyl alkyloxyacetate (for example, methyl methoxyacetate, ethyl methoxyacetate, butyl methoxyacetate, methyl ethoxyacetate, and ethyl ethoxyacetate)), alkyl 3-alkyloxypropionate esters (example: methyl 3-alkyloxypropionate and ethyl 3-alkyloxypropionate (for example, methyl 3-methoxypropionate, ethyl 3-methoxypropionate, methyl 3-ethoxypropionate, and ethyl 3-ethoxypropionate)), alkyl 2-alkyloxypropionate esters (example: methyl 2-alkyloxypropionate, ethyl 2-alkyloxypropionate, and propyl 2-alkyloxypropionate (for example, methyl 2-methoxypropionate, ethyl 2-methoxypropionate, propyl 2-methoxypropionate, methyl 2-ethoxypropionate, and ethyl 2-ethoxypropionate)), methyl 2-alkyloxy-2-methyl propionate, ethyl 2-alkyloxy-2-methyl propionate (for example, methyl 2-methoxy-2-methyl propionate and ethyl 2-ethoxy-2-methyl propionate), methyl pyruvate, ethyl pyruvate, propyl pyruvate, methyl acetoacetate, ethyl acetoacetate, methyl 2-oxobutanoate, ethyl 2-oxobutanoate, 1-methoxy-2-propylacetate, ethyl carbitol acetate, butyl carbitol acetate, propylene glycol methyl ether, and propylene glycol methyl ether acetate;
ethers such as diethylene glycol dimethyl ether, tetrahydrofuran, ethylene glycol monomethyl ether, ethylene glycol monoethyl ether, methyl cellosolve acetate, ethyl cellosolve acetate, diethylene glycol monomethyl ether, diethylene glycol monoethyl ether, diethylene glycol monobutyl ether, propylene glycol monomethyl ether, propylene glycol monomethyl ether acetate, propylene glycol monoethyl ether acetate, and propylene glycol monopropyl ether acetate;
ketones such as methyl ethyl ketone, cyclohexanone, 2-heptanone, 3-heptanone, N-methyl-2-pyrrolidone, and γ-butyrolactone;
aromatic hydrocarbons such as toluene, xylene, anisole, mesitylene, ethyl benzene, propyl benzene, cumene, n-butylbenzene, sec-butylbenzene, isobutylbenzene, t-butylbenzene, amylbenzene, isoamylbenzene, (2,2-dimethylpropyl)benzene, 1-phenylhexane, 1-phenylheptane, 1-phenyloctane, 1-phenylnonane, 1-phenyldecane, cyclopropylbenzene, cyclohexylbenzene, 2-ethyltoluene, 1,2-diethylbenzene, o-cymene, indane, 1,2,3,4-tetrahydronaphthalene, 3-ethyltoluene, m-cymene, 1,3-diisopropylbenzene, 4-ethyltoluene, 1,4-diethylbenzene, p-cymene, 1,4-diisopropylbenzene, 4-t-butyl toluene, 1,4-di-t-butylbenzene, 1,3-diethylbenzene, 1,2,3-trimethylbenzene, 1,2,4-trimethylbenzene, 4-t-butyl-o-xylene, 1,2,4-triethylbenzene, 1,3,5-triethylbenzene, 1,3,5-triisopropylbenzene, 5-t-butyl-m-xylene, 3,5-di-t-butyltoluene, 1,2,3,5-tetramethylbenzene, 1,2,4,5-tetramethylbenzene, and pentamethyl benzene; and
hydrocarbons such as limonene, p-menthane, nonane, decane, dodecane, and decalin.

Among these, mesitylene, t-butylbenzene, 1,2,4-trimethylbenzene, p-menthane, γ-butyrolactone, anisole, methyl 3-ethoxypropionate, ethyl 3-ethoxypropionate, ethyl cellosolve acetate, ethyl lactate, diethylene glycol dimethyl ether, butyl acetate, methyl 3-methoxypropionate, 2-heptanone, cyclohexanone, ethyl carbitol acetate, butyl carbitol acetate, propylene glycol methyl ether, and propylene glycol methyl ether acetate are preferable.

These solvents are also preferably used as a mixture of two or more types from the viewpoint of an improvement of a coating surface state and the like. In this case, a mixed solution of two or more types selected from mesitylene, t-butylbenzene, 1,2,4-trimethylbenzene, p-menthane, γ-butyrolactone, anisole, methyl 3-ethoxypropionate, ethyl 3-ethoxypropionate, ethyl cellosolve acetate, ethyl lactate, diethylene glycol dimethyl ether, butyl acetate, methyl 3-methoxypropionate, 2-heptanone, cyclohexanone, ethyl carbitol acetate, butyl carbitol acetate, propylene glycol methyl ether, and propylene glycol methyl ether acetate is particularly preferable.

From the viewpoint of coatability, the solvent content of the composition for temporary adhesion is set such that the concentration of the temporary adhesive film forming component contained in the composition for temporary adhesion is preferably 5 to 80 mass%, more preferably 10 to 50 mass%, and particularly preferably 15 to 40 mass%.

Only one type of solvent, or two or more types of solvents may be contained. In a case where two or more types of solvents are contained, the total content thereof is preferably within the above range.

The solvent content of the temporary adhesive film obtained by applying and drying the composition for temporary adhesion in the form of a layer is preferably 1 mass% or less, and more preferably 0.1 mass% or less. It is particularly preferable that no solvent is contained.

<<<Antioxidant>>>

The composition for temporary adhesion used in the invention may contain an antioxidant. As the antioxidant, a phenol-based antioxidant, a sulfur-based antioxidant, a phosphorus-based antioxidant, a quinone-based antioxidant, an amine-based antioxidant, or the like can be used.

Examples of the phenol-based antioxidant include p-methoxyphenol, 2,6-di-tert-butyl-4-methylphenol, Irganox 1010, Irganox 1330, Irganox 3114, and Irganox 1035 (all manufactured by BASF Japan Ltd.), and Sumilizer MDP-S and Sumilizer GA-80 (all manufactured by Sumitomo Chemical Co., Ltd.).

Examples of the sulfur-based antioxidant include distearyl 3,3'-thiodipropionate, Sumilizer TPM, Sumilizer TPS, and Sumilizer TP-D (all manufactured by Sumitomo Chemical Co., Ltd.).

Examples of the phosphorus-based antioxidant include tris(2,4-di-tert-butylphenyl)phosphite, bis(2,4-di-tert-butylphenyl)pentaerythritol diphosphite, poly(dipropylene glycol)phenyl phosphite, diphenyl isodecyl phosphite, 2-ethylhexyl diphenyl phosphite, triphenyl phosphite, Irgafos 168, and Irgafos 38 (all manufactured by BASF Japan Ltd.).

Examples of the quinone-based antioxidant include p-benzoquinone and 2-tert-butyl-1,4-benzoquinone.

Examples of the amine-based antioxidant include dimethylaniline and phenothiazine.

The antioxidant is preferably Irganox 1010, Irganox 1330, distearyl 3,3'-thiodipropionate, or Sumilizer TP-D, more preferably Irganox 1010 or Irganox 1330, and particularly preferably Irganox 1010.

Among the above antioxidants, a phenol-based antioxidant is preferably used in combination with a sulfur-based antioxidant or a phosphorus-based antioxidant, and most preferably used in combination with a sulfur-based antioxidant. Particularly, in a case where a polystyrene-based elastomer is used as the elastomer, a phenol-based antioxidant is preferably used in combination with a sulfur-based antioxidant. With such a combination, it is possible to expect efficient suppression of degradation of the composition for temporary adhesion by the oxidation reaction. In a case where a phenol-based antioxidant and a sulfur-based antioxidant are used in combination, the mass ratio between the phenol-based antioxidant and the sulfur-based antioxidant is preferably 95:5 to 5:95, and more preferably 75:25 to 25:75 (phenol-based antioxidant:sulfur-based antioxidant).

Regarding combination of the antioxidants, Irganox 1010 and Sumilizer TP-D, Irganox 1330 and Sumilizer TP-D, and Sumilizer GA-80 and Sumilizer TP-D are preferably used in combination. In addition, Irganox 1010 and Sumilizer TP-D, and Irganox 1330 and Sumilizer TP-D are more preferably used in combination. Irganox 1010 and Sumilizer TP-D are particularly preferably used in combination.

From the viewpoint of prevention of sublimation during heating, the molecular weight of the antioxidant is preferably 400 or greater, more preferably 600 or greater, and particularly preferably 750 or greater.

In a case where the composition for temporary adhesion contains an antioxidant, the antioxidant content is preferably 0.001 to 20.0 mass%, and more preferably 0.005 to 10.0 mass% with respect to the temporary adhesive film forming component in the composition for temporary adhesion, that is, the temporary adhesive film.

Only one type of antioxidant, or two or more types of antioxidants may be contained. In a case where two or more types of antioxidants are contained, the total content thereof is preferably within the above range.

<<<Plasticizer>>>

The composition for temporary adhesion used in the invention may contain a plasticizer as necessary. A

temporary adhesive film satisfying the various performances described above can be formed by mixing a plasticizer.

As the plasticizer, a phthalic acid ester, a fatty acid ester, an aromatic polycarboxylic acid ester, a polyester, or the like can be used.

Examples of the phthalic acid ester include DMP, DEP, DBP, #10, BBP, DOP, DINP, and DIDP (all manufactured by DAIHACHI CHEMICAL INDUSTRY CO., LTD.), PL-200 and DOIP (all manufactured by CG Ester Corporation), and Sansocizer DUP (manufactured by New Japan Chemical Co., Ltd.).

Examples of the fatty acid ester include butyl stearate, UNISTAR M-9676, UNISTAR M-2222SL, UNISTAR H-476, UNISTAR H-476D, Panasate 800B, Panasate 875, and Panasate 810 (all manufactured by NOF), and DBA, DIBA, DBS, DOA, DINA, DIDA, DOS, BXA, DOZ, and DESU (all manufactured by DAIHACHI CHEMICAL INDUSTRY CO., LTD.).

Examples of the aromatic polycarboxylic acid ester include TOTM (manufactured by DAIHACHI CHEMICAL INDUSTRY CO., LTD.), Monocizer W-705 (manufactured by DAIHACHI CHEMICAL INDUSTRY CO., LTD.), and UL-80 and UL-100 (manufactured by ADEKA CORPORATION).

Examples of the polyester include POLYCIZER TD-1720, POLYCIZER S-2002, and POLYCIZER S-2010 (all manufactured by DIC Corporation), and BAA-15 (manufactured by DAIHACHI CHEMICAL INDUSTRY CO., LTD.).

Among the above plasticizers, DIDP, DIDA, TOTM, UNISTAR M-2222SL, and POLYCIZER TD-1720 are preferable, DIDA and TOTM are more preferable, and TOTM is particularly preferable.

The plasticizers may be used singly or in combination of two or more types thereof.

In a case where a change in weight of the plasticizer is measured at a constant rate of temperature increase of 20°C/min under a nitrogen gas flow, the temperature at which the weight is decreased 1 mass% is preferably 250°C or higher, more preferably 270°C or higher, and particularly preferably 300°C or higher from the viewpoint of prevention of sublimation during heating. The upper limit is not particularly limited, and can be set to, for example, 500°C or lower.

The amount of the plasticizer added is preferably 0.01 mass% to 5.0 mass%, and more preferably 0.1 mass% to 2.0 mass% with respect to the temporary adhesive film forming component in the composition for temporary adhesion, that is, the temporary adhesive film.

<<<Other Additives>>>

In the composition for temporary adhesion used in the invention, in addition to the above-described additives, various additives such as a curing agent, a curing catalyst, a filler, an adhesion promoter, an ultraviolet absorber, and an aggregation inhibitor may be mixed as necessary within a range not impairing the effects of the invention. In a case where these additives are mixed, the total mixing amount thereof is preferably 3 mass% or less of the temporary adhesive film forming component, that is, the temporary adhesive film.

The composition for temporary adhesion used in the invention preferably contains no impurities such as metals. The impurity content is preferably 1 mass ppm (parts per million) or less, more preferably 100 mass ppt (parts per trillion) or less, and even more preferably 10 mass ppt or less. It is particularly preferable that no impurities are substantially contained (the impurity content is not greater than the detection limit of a measuring device).

Examples of the method of removing impurities such as metals from the composition for temporary adhesion include filtration using a filter. The filter pore size is preferably 10 nm or less, more preferably 5 nm or less, and even more preferably 3 nm or less. Regarding the material of the filter, filters made of polytetrafluoroethylene, polyethylene, or nylon are preferable. As the filter, a filter pre-washed with an organic solvent may be used. In the filtering step, a plurality of types of filters connected in series or in parallel may be used. In a case where a plurality of types of filters are used, filters different in pore size and/or material may be used in combination. The filtration may be performed a plurality of times using various filter materials, and the step of performing filtration a plurality of times may be provided as a circulating filtration step.

In addition, examples of the method of reducing impurities such as metals contained in the composition for temporary adhesion include methods such as selecting a raw material having a small metal content as a raw material of the composition for temporary adhesion, filtering a raw material of the composition for temporary adhesion, and lining the inside of the device with TEFLON (registered trademark) to perform distillation under the condition where contamination is suppressed as much as possible. Preferable conditions for filtering which is performed on the raw material of the composition for temporary adhesion are the same as the above-mentioned conditions.

Other than filtering, an adsorbing material may be used to remove impurities, or filtering and an adsorbing material may be used in combination. A known adsorbing material can be used as the adsorbing material, and for example, inorganic adsorbing materials such as silica gel and zeolite, or organic adsorbing materials such as activated carbon can be used.

<<<Preparation of Composition for Temporary Adhesion>>>

The composition for temporary adhesion can be prepared by mixing the above-described components. In general, the components are mixed within a range of 0°C to 100°C. After mixing the components, the mixture is preferably filtered using, for example, a filter. The filtration may be performed in multiple stages or repeated many times. It is also possible to re-filter the filtered solution.

The filter can be used without any particular limitation as long as it has been used for filtration purposes. Examples thereof include filters made of a fluorine resin such as polytetrafluoroethylene (PTFE), a polyamide-based resin such as nylon-6 or nylon-6, 6, or a polyolefin resin such as polyethylene or polypropylene (PP) (including a polyolefin resin having an ultrahigh molecular weight). Among these materials, polypropylene (including high density polypropylene) and nylon are preferable.

A suitable pore size of the filter is about 0.003 to 5.0 μm. Within the above range, it is possible to securely remove fine foreign matters such as impurities and aggregates contained in the composition while suppressing filter clogging.

In a case where a filter is used, different filters may be combined. In that case, filtering using a first filter may be performed once or more than once. In a case where different filters are combined to perform filtering two or more times, the pore size in first filtering is preferably the same as or smaller than the pore size in second or later filtering. It may be also possible to combine first filters having different pore sizes within the above-described range. Herein, regarding the pore sizes, the nominal values of the filter makers can be referred to. A commercially available filter can be selected from various filters offered by Nihon Pall Ltd., Advantec Toyo Kaisha, Ltd., Entegris Japan Co., Ltd., or Kitz Micro Filter Corporation.

<Resin Pattern>

The laminate according to the embodiment of the invention includes a resin pattern. The resin pattern is positioned on the surface of the temporary adhesive film. In a case where the resin pattern is directly provided on the surface of the temporary adhesive film as above, it is possible to manufacture a semiconductor device by an RDL-first method. Furthermore, the resin pattern contains a surfactant. In a case where the resin pattern contains a surfactant, it is possible to effectively suppress mixing of the resin pattern and the temporary adhesive film at an interface therebetween.

Examples of the resin contained in the resin pattern include a polyimide resin, a polybenzoxazole resin, an epoxy resin, a phenol resin, and an acrylic resin. A polyimide resin and a polybenzoxazole resin are preferable, and a polyimide resin is more preferable.

The resin pattern may contain other components in addition to the resin and the surfactant without departing from the gist of the invention. Details of the surfactant and other components have the same meanings as those of the surfactant and other components to be described in Photosensitive Resin Composition to be described later.

In the invention, the resin pattern can be formed using a photosensitive resin composition. Specifically, after a step of applying a photosensitive resin composition containing a resin and a surfactant in the form of a layer, a step of forming a resin pattern by exposing and developing the layer-like photosensitive resin composition is performed. The photosensitive resin composition may be a photosensitive resin composition for negative development or a photosensitive resin composition for positive development. In the invention, a photosensitive resin composition for negative development is preferable. Details of the method of forming a resin pattern will be described later.

<<Photosensitive Resin Composition>>

In the invention, the resin pattern is preferably formed using a photosensitive resin composition. The photosensitive resin composition contains a component which forms a resin which is a main component of the resin pattern by exposure and development and a surfactant.

Examples of the component forming a resin, which is a main component of the resin pattern, by exposure and development include a photosensitive resin, a mixture of a photosensitive resin and a polymerizable compound, a mixture of a non-photosensitive resin and a polymerizable compound, and a polymerizable compound.

<<<Resin>>>

Examples of the resin used in the photosensitive resin composition include a heterocyclic ring-containing polymer precursor (preferably, a polyimide precursor and a polybenzoxazole precursor), a polyimide resin, a polybenzoxazole resin, an epoxy resin, a phenol resin, and a benzocyclobutene resin. At least one type of heterocyclic ring-containing polymer precursor is preferably contained, and at least one type of polyimide precursor is more preferably contained.

<<<<Polyimide Precursor>>>>

The type and the like of the polyimide precursor used in the invention are not particularly specified, and a repeating unit represented by Formula (2) is preferably contained.

Formula (2)

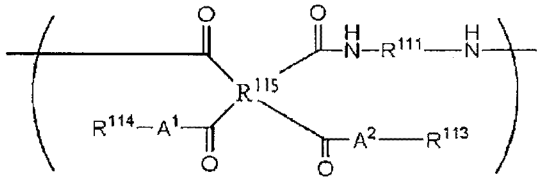

In Formula (2), $A^1$ and $A^2$ each independently represent an oxygen atom or NH, $R^{111}$ represents a divalent organic group, $R^{115}$ represents a tetravalent organic group, and $R^{113}$ and $R^{114}$ each independently represent a hydrogen atom or a monovalent organic group.

In Formula (2), $A^1$ and $A^2$ preferably represent an oxygen atom or NH, and more preferably an oxygen atom.

In Formula (2), $R^{111}$ represents a divalent organic group. Examples of the divalent organic group include a linear or branched aliphatic group, a cyclic aliphatic group, and a group containing an aromatic group. A linear or branched aliphatic group having 2 to 20 carbon atoms, a cyclic aliphatic group having 6 to 20 carbon atoms, an aromatic group having 6 to 20 carbon atoms, or a group containing a combination thereof is preferable, and a group containing an aromatic group having 6 to 20 carbon atoms is more preferable. In the invention, a group represented by -Ar-L-Ar- is particularly preferable. Ar's each independently represent an aromatic group, and L represents an aliphatic hydrocarbon group having 1 to 10 carbon atoms which may be substituted with a fluorine atom, -O-, -CO-, -S-, $-SO_2-$, or -NHCO-, or a group having a combination of two or more of the above. The preferable ranges thereof are as described above.

$R^{111}$ is preferably derived from a diamine. Examples of the diamine used for manufacturing a polyimide precursor include a linear or branched aliphatic diamine, a cyclic aliphatic diamine, and an aromatic diamine. Only one type of diamine, or two or more types of diamines may be used.

Specifically, a diamine containing a linear or branched aliphatic group having 2 to 20 carbon atoms, a cyclic aliphatic group having 6 to 20 carbon atoms, an aromatic group having 6 to 20 carbon atoms, or a group containing a combination thereof is preferable, and a diamine containing a group containing an aromatic group having 6 to 20 carbon atoms is more preferable. Examples of the aromatic group are as follows.

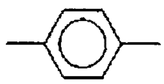 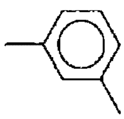 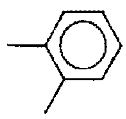 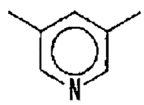

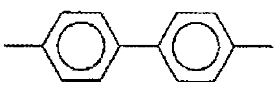 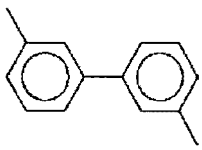 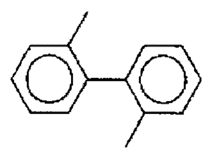

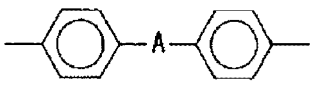 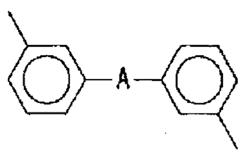 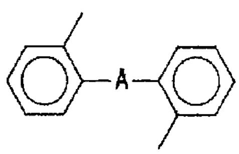

In the formulae, A is preferably a single bond or a group selected from an aliphatic hydrocarbon group having 1 to 10 carbon atoms which may be substituted with a fluorine atom, -O-, -C(=O)-, -S-, $-SO_2-$, -NHCO-, and a combination thereof, more preferably a single bond or a group selected from an alkylene group having 1 to 3 carbon atoms which may be substituted with a fluorine atom, -O-, -C(=O)-, -S-, and $-SO_2-$, and even more preferably a divalent group selected from the group consisting of $-CH_2-$, -O-, -S-, $-SO_2-$, $-C(CF_3)_2-$, and $-C(CH_3)_2-$.

Specifically, regarding the diamine, the description in paragraph 0083 in JP2016-027357A can be referred to, and the contents thereof are incorporated herein.

Diamines (DA-1) to (DA-18) shown below are also preferable.

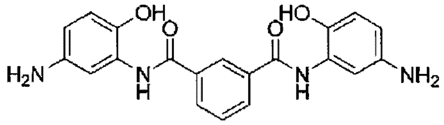

(DA-1)

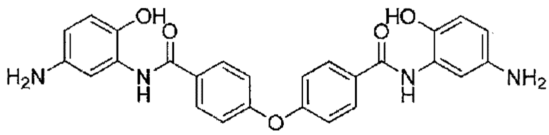

(DA-2)

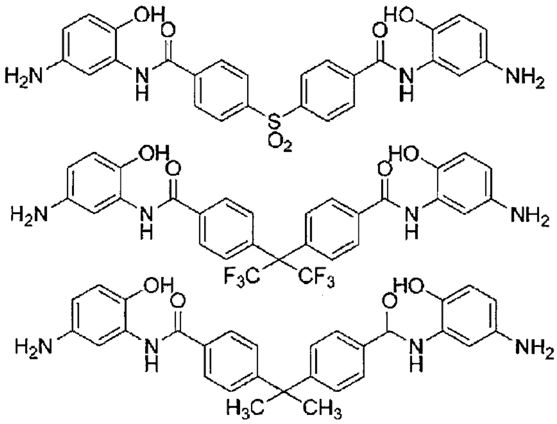

(DA-3)

(DA-4)

(DA-5)

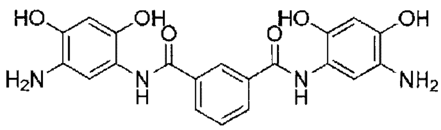

(DA-6)

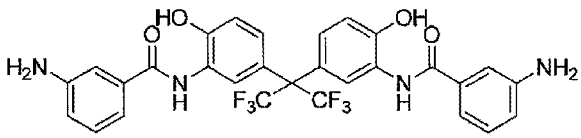

(DA-7)

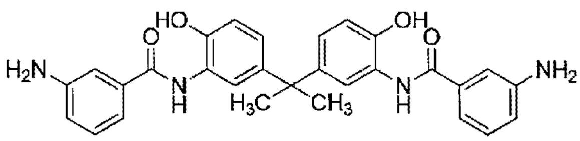

(DA-8)

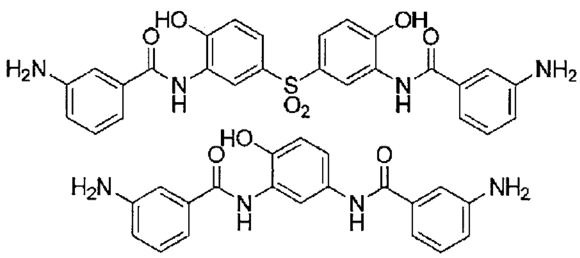

(DA-9)

(DA-10)

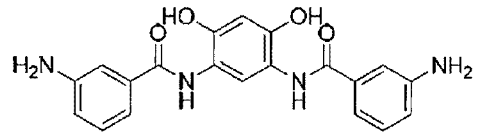

(DA-11)

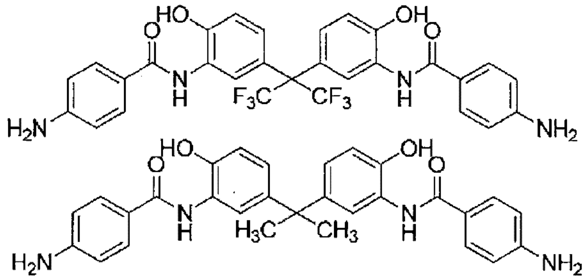

(DA-12)

(DA-13)

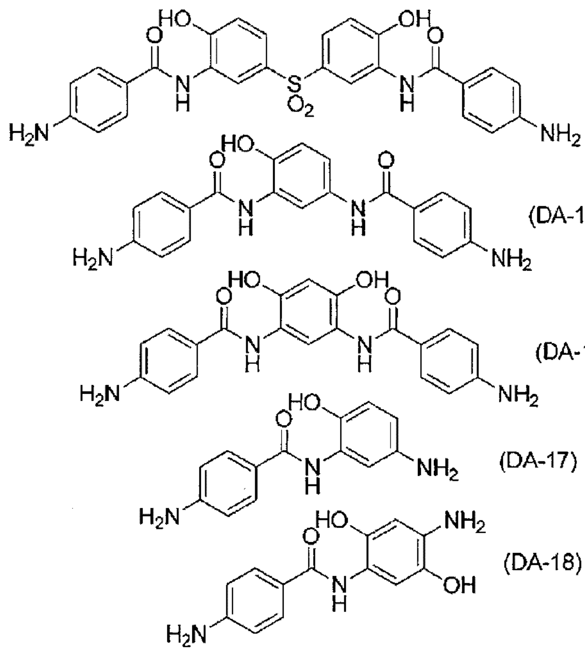

(DA-14)

(DA-15)

(DA-16)

(DA-17)

(DA-18)

Preferable examples of the diamine also include a diamine having at least two alkylene glycol units in a main chain. A diamine containing two or more ethylene glycol chain(s) and/or propylene glycol chain(s) in total in a molecule is more preferable, and a diamine containing no aromatic ring is even more preferable. Specific examples thereof include, but are not limited to, JEFFAMINE (registered trademark) KH-511, JEFFAMINE (registered trademark) ED-600, JEFFAMINE (registered trademark) ED-900, JEFFAMINE (registered trademark) ED-2003, JEFFAMINE (registered trademark) EDR-148, JEFFAMINE (registered trademark) EDR-176, JEFFAMINE (registered trademark) D-200, JEFFAMINE (registered trademark) D-400, JEFFAMINE (registered trademark) D-2000, and JEFFAMINE (registered trademark) D-4000 (which are all trade names, manufactured by HUNTSMAN Corporation), 1-(2-(2-(2-aminopropoxy)ethoxy)propoxy)propane-2-amine, and 1-(1-(1-(2-aminopropoxy)propane-2-yl)oxy)propane-2-amine.

Structures of JEFFAMINE (registered trademark) KH-511, JEFFAMINE (registered trademark) ED-600, JEFFAMINE (registered trademark) ED-900, JEFFAMINE (registered trademark) ED-2003, JEFFAMINE (registered trademark) EDR-148, and JEFFAMINE (registered trademark) EDR-176 are shown as below.

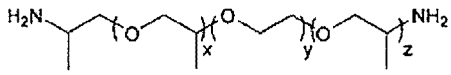

KH−511 (y = 2. 0、x+z = 1. 2)
ED−600 (y = 9. 0、x+z = 3. 6)
ED−900 (y = 12. 5、x+z = 6. 0)
ED−2003 (y = 39. 0、 x+z = 6. 0)

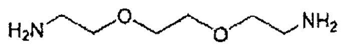

EDR-148

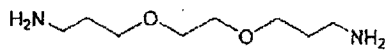

EDR-176

x, y, and z are average values.

From the viewpoint of flexibility of a cured film to be obtained, $R^{111}$ is preferably represented by -Ar-L-Ar-. Ar's each independently represent an aromatic group, and L represents an aliphatic hydrocarbon group having 1 to 10 carbon atoms which may be substituted with a fluorine atom, -O-, -CO-, -S-, $-SO_2-$, or -NHCO-, or a group having a combination of two or more of the above. Ar is preferably a phenylene group, and L is preferably an aliphatic hydrocarbon group having 1 or 2 carbon atoms which may be substituted with a fluorine atom, -O-, -CO-, -S-, or $-SO_2-$. Here, the aliphatic hydrocarbon group is preferably an alkylene group.

$R^{111}$ is preferably a divalent organic group represented by Formula (51) or Formula (61) from the viewpoint of i-ray transmittance. Particularly, $R^{111}$ is more preferably a divalent organic group represented by Formula (61) from the viewpoint of i-ray transmittance and easy acquisition.

Formula (51)

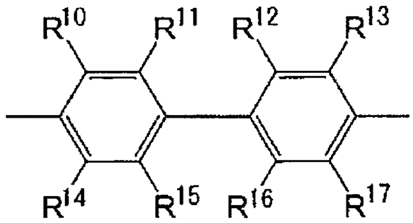

(51)

In Formula (51), $R^{10}$ to $R^{17}$ each independently represent a hydrogen atom, a fluorine atom, or a monovalent organic group, and at least one of $R^{10}$, $R^{11}$, $R^{12}$, $R^{13}$, $R^{14}$, $R^{15}$, $R^{16}$, or $R^{17}$ is a fluorine atom, a methyl group, or a trifluoromethyl group.

Examples of the monovalent organic group represented by each of $R^{10}$ to $R^{17}$ include an unsubstituted alkyl group having 1 to 10 carbon atoms (preferably 1 to 6 carbon atoms) and a fluorinated alkyl group having 1 to 10 carbon atoms (preferably 1 to 6 carbon atoms).

Formula (61)

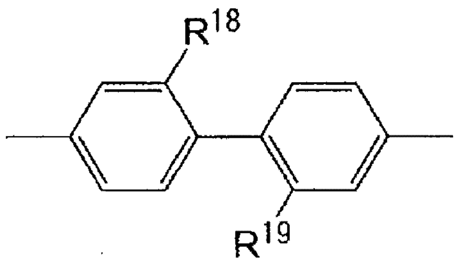

(61)

In Formula (61), $R^{18}$ and $R^{19}$ each independently represent a fluorine atom or a trifluoromethyl group.

Examples of the diamine compound providing the structure of Formula (51) or (61) include 2,2' -dimethylbenzidine, 2,2' -bis(trifluoromethyl)-4,4' -diaminobiphenyl, 2,2'-bis(fluoro)-4,4'-diaminobiphenyl, and 4,4'-diaminooctafluorobiphenyl. These may be used singly or in combination of two or more types thereof.

In Formula (2), $R^{115}$ represents a tetravalent organic group. As the tetravalent organic group, a tetravalent organic group containing an aromatic ring is preferable, and a group represented by Formula (5) or Formula (6) is more preferable.

Formula (5)

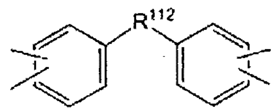

In Formula (5), $R^{112}$ is preferably a single bond or a group selected from an aliphatic hydrocarbon group having 1 to 10 carbon atoms which may be substituted with a fluorine atom, -O-, -CO-, -S-, $-SO_2-$, -NHCO-, and a combination thereof, more preferably a single bond or a group selected from an alkylene group having 1 to 3 carbon atoms which may be substituted with a fluorine atom, -O-, -CO-, -S-, and $-SO_2-$, and even more preferably a divalent group selected from the group consisting of $-CH_2-$, $-C(CF_3)_2-$, $-C(CH_3)_2-$, -O-, -CO-, -S-, and $-SO_2-$.

Formula (6)

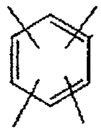

Specific examples of $R^{115}$ include a tetracarboxylic acid residue remaining after removal of an acid anhydride group from a tetracarboxylic dianhydride. The tetracarboxylic dianhydride may be used singly or in combination of two or more types thereof.

The tetracarboxylic dianhydride is preferably represented by Formula (O).

Formula (O)

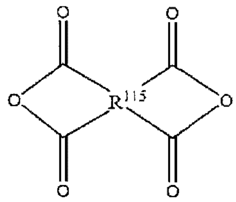

(O)

In Formula (O), $R^{115}$ represents a tetravalent organic group. $R^{115}$ has the same meaning as that of $R^{115}$ in Formula (2), and the preferable ranges thereof are the same as those of $R^{115}$ in Formula (2).

Specific examples of the tetracarboxylic dianhydride include pyromellitic dianhydride (PMDA), 3,3',4,4'-biphenyltetracarboxylic dianhydride, 3,3',4,4'-diphenylsulfide tetracarboxylic dianhydride, 3,3',4,4'-diphenylsulfone tetracarboxylic dianhydride, 3,3',4,4'-benzophenonetetracarboxylic dianhydride, 3,3',4,4'-diphenylmethanetetracarboxylic dianhydride, 2,2',3,3'-diphenylmethanetetracarboxylic dianhydride, 2,3,3',4'-biphenyltetracarboxylic dianhydride, 2,3,3',4'-benzophenonetetracarboxylic dianhydride, 4,4'-oxydiphthalic dianhydride, 2,3,6,7-naphthalenetetracarboxylic dianhydride, 1,4,5,7-naphthalenetetracarboxylic dianhydride, 2,2-bis(3,4-dicarboxyphenyl)propane dianhydride, 2,2-bis(2,3-dicarboxyphenyl)propane dianhydride, 2,2-bis(3,4-dicarboxyphenyl)hexafluoropropane dianhydride, 1,3-diphenylhexafluoropropane-3,3,4,4-tetracarboxylic dianhydride, 1,4,5,6-naphthalenetetracarboxylic dianhydride, 2,2',3,3'-diphenyltetracarboxylic dianhydride, 3,4,9,10-perylenetetracarboxylic dianhydride, 1,2,4,5-naphthalenetetracarboxylic dianhydride, 1,4,5,8-naphthalenetetracarboxylic dianhydride, 1,8,9,10-phenanthrenetetracarboxylic dianhydride, 1,1-bis(2,3-dicarboxyphenyl)ethane dianhydride, 1,1-bis(3,4-dicarboxyphenyl)ethane dianhydride, 1,2,3,4-benzenetetracarboxylic dianhydride, and at least one type selected from alkyl derivatives having 1 to 6 carbon atoms and/or alkoxy derivatives having 1 to 6 carbon atoms thereof.

Tetracarboxylic dianhydrides (DAA-1) to (DAA-5) shown below are also included as preferable examples.

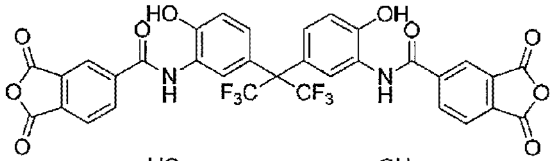

(DAA-1)

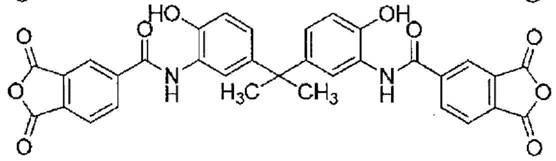

(DAA-2)

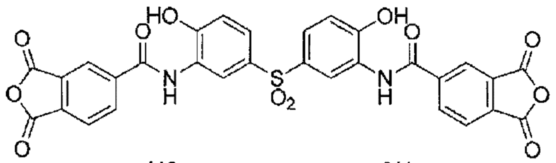

(DAA-3)

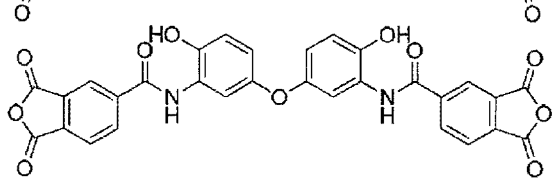

(DAA-4)

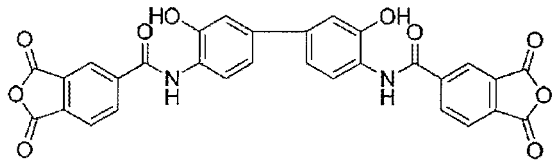

(DAA-5)

In addition, at least one of $R^{111}$ or $R^{115}$ preferably has an OH group. More specifically, examples of $R^{111}$ include a residue of a bisaminophenol derivative.

$R^{113}$ and $R^{114}$ each independently represent a hydrogen atom or a monovalent organic group. It is preferable that at least one of $R^{113}$ or $R^{114}$ contains a polymerizable group, and it is more preferable that both $R^{113}$ and $R^{114}$ contain a polymerizable group. The polymerizable group is a group capable of undergoing a crosslinking reaction by the action of heat, light, or the like, and is preferably a photo-radical polymerizable group. Specific examples of the polymerizable group include a group having an ethylenically unsaturated bond, an alkoxymethyl group, a hydroxymethyl group, an acyloxymethyl group, an epoxy group, an oxetanyl group, a benzoxazolyl group, a block isocyanate group, a methylol group, and an amino group. As a radical polymerizable group of the polyimide precursor or the like, a group having an ethylenically unsaturated bond is preferable.

Examples of the group having an ethylenically unsaturated bond include a vinyl group, a (meth)allyl group, and a group represented by Formula (III).

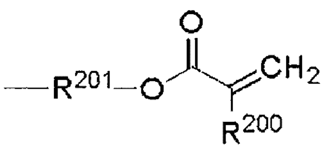

(III)

In Formula (III), $R^{200}$ represents a hydrogen atom or a methyl group, and a methyl group is more preferable.

In Formula (III), $R^{201}$ represents an alkylene group having 2 to 12 carbon atoms, $-CH_2CH(OH)CH_2-$, or a polyoxyalkylene group having 4 to 30 carbon atoms.

Suitable examples of $R^{201}$ include an ethylene group, a propylene group, a trimethylene group, a tetramethylene group, a 1,2-butanediyl group, a 1,3-butanediyl group, a pentamethylene group, a hexamethylene group, an octamethylene group, a dodecamethylene group, and $-CH_2CH(OH)CH_2-$, and an ethylene group, a propylene group, a trimethylene group, and $-CH_2CH(OH)CH_2-$ are more preferable.

Particularly preferably, $R^{200}$ is a methyl group, and $R^{201}$ is an ethylene group.

$R^{113}$ or $R^{114}$ may be a hydrogen atom or a monovalent organic group. Examples of the monovalent organic group include an aromatic group and an aralkyl group having 1, 2 or 3, preferably 1 acidic group bonded to a carbon of the aryl group. Specific examples thereof include an aromatic group having an acidic group with 6 to 20 carbon atoms

and an aralkyl group having an acidic group with 7 to 25 carbon atoms. More specific examples thereof include a phenyl group having an acidic group and a benzyl group having an acidic group. The acidic group is preferably an OH group.

$R^{113}$ or $R^{114}$ is more preferably a hydrogen atom, 2-hydroxybenzyl, 3-hydroxybenzyl, or 4-hydroxybenzyl.

$R^{113}$ or $R^{114}$ is preferably a monovalent organic group from the viewpoint of solubility in an organic solvent. As the monovalent organic group, a linear or branched alkyl group, a cyclic alkyl group, or an aromatic group is preferably contained, and an alkyl group substituted with an aromatic group is more preferable.

The number of carbon atoms of the alkyl group is preferably 1 to 30. The alkyl group may be linear, branched, or cyclic. Examples of the linear or branched alkyl group include a methyl group, an ethyl group, a propyl group, a butyl group, a pentyl group, an hexyl group, an heptyl group, an octyl group, a nonyl group, a decyl group, a dodecyl group, a tetradecyl group, an octadecyl group, an isopropyl group, an isobutyl group, a sec-butyl group, a t-butyl group, a 1-ethylpentyl group, and a 2-ethylhexyl group. The cyclic alkyl group may be a monocyclic alkyl group or a polycyclic alkyl group. Examples of the monocyclic cyclic alkyl group include a cyclopropyl group, a cyclobutyl group, a cyclopentyl group, a cyclohexyl group, a cycloheptyl group, and a cyclooctyl group. Examples of the polycyclic alkyl group include an adamantyl group, a norbornyl group, a bornyl group, a canphenyl group, a decahydronaphthyl group, a tricyclodecanyl group, a tetracyclodecanyl group, a camphoroyl group, a dicyclohexyl group, and a pinenyl group. Among these, a cyclohexyl group is most preferable from the viewpoint of compatibility with high sensitivity. In addition, the alkyl group substituted with an aromatic group is preferably a linear alkyl group substituted with an aromatic group to be described later.

Specific examples of the aromatic group include a substituted or unsubstituted benzene ring, a naphthalene ring, a pentalene ring, an indene ring, an azulene ring, a heptalene ring, an indacene ring, a perylene ring, a pentacene ring, an acenaphthene ring, a phenanthrene ring, an anthracene ring, a naphthacene ring, a chrysene ring, a triphenylene ring, a fluorene ring, a biphenyl ring, a pyrrole ring, a furan ring, a thiophene ring, an imidazole ring, an oxazole ring, a thiazole ring, a pyridine ring, a pyrazine ring, a pyrimidine ring, a pyridazine ring, an indolizine ring, an indole ring, a benzofuran ring, a benzothiophene ring, an isobenzofuran ring, a quinolizine ring, a quinoline ring, a phthalazine ring, a naphthyridine ring, a quinoxaline ring, a quinoxazoline ring, an isoquinoline ring, a carbazole ring, a phenanthridine ring, an acridine ring, a phenanthroline ring, a thianthrene ring, a chromene ring, a xanthene ring, a phenoxathiin ring, a phenothiazine ring, and a phenazine ring. A benzene ring is most preferable.

In Formula (2), in a case where $R^{113}$ is a hydrogen atom, or $R^{114}$ is a hydrogen atom, the polyimide precursor may form a counter salt with a tertiary amine compound having an ethylenically unsaturated bond. Examples of the tertiary amine compound having an ethylenically unsaturated bond include N,N-dimethylaminopropyl methacrylate.

The polyimide precursor preferably has a fluorine atom in the structural unit. The fluorine atom content in the polyimide precursor is preferably 10 mass% or greater, and more preferably 20 mass% or less.

The repeating unit represented by Formula (2) is preferably a repeating unit represented by Formula (2-A). That is, at least one type of polyimide precursor or the like used in the invention is preferably a precursor having a repeating unit represented by Formula (2-A). With such a structure, the width of exposure latitude can be widened.

Formula (2-A)

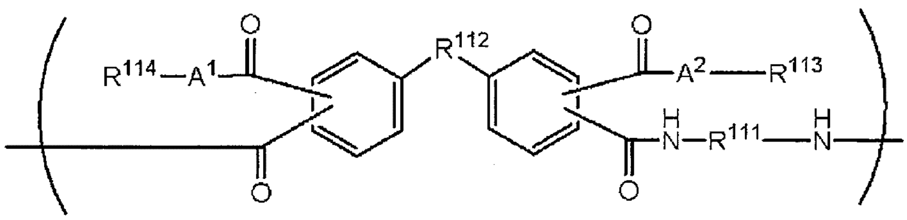

In Formula (2-A), $A^1$ and $A^2$ represent an oxygen atom, $R^{111}$ and $R^{112}$ each independently represent a divalent organic group, $R^{113}$ and $R^{114}$ each independently represent a hydrogen atom or a monovalent organic group, and at least one of $R^{113}$ or $R^{114}$ is a group containing a polymerizable group.

$A^1$, $A^2$, $R^{111}$, $R^{113}$, and $R^{114}$ each independently have the same meanings as those of $A^1$, $A^2$, $R^{111}$, $R^{113}$, and $R^{114}$ in Formula (2), and the preferable ranges thereof are the same as those of $A^1$, $A^2$, $R^{111}$, $R^{113}$, and $R^{114}$ in Formula (2). $R^{112}$ has the same meaning as that of $R^{112}$ in Formula (5), and the preferable ranges thereof are the same as those of $R^{112}$ in Formula (5).

The polyimide precursor may contain only one type of repeating structural unit represented by Formula (2), or two or more types of repeating structural units represented by Formula (2). Further, it may contain a structural isomer of the repeating unit represented by Formula (2). It is needless to say that the polyimide precursor may contain other types of repeating structural units in addition to the repeating unit represented by Formula (2).

In the invention, as an embodiment of the polyimide precursor, a polyimide precursor in which at least 50 mol%,

more preferably at least 70 mol%, and particularly preferably at least 90 mol% of all repeating units is a repeating unit represented by Formula (2) is exemplified.

The weight-average molecular weight (Mw) of the polyimide precursor is preferably 18,000 to 30,000, more preferably 20,000 to 27,000, and even more preferably 22,000 to 25,000. The number-average molecular weight (Mn) is preferably 7,200 to 14,000, more preferably 8,000 to 12,000, and even more preferably 9,200 to 11,200.

The degree of dispersion of the polyimide precursor is preferably 2.5 or greater, more preferably 2.7 or greater, and even more preferably 2.8 or greater. The upper limit value of the degree of dispersion of the polyimide precursor is not particularly specified. For example, the upper limit value is preferably 4.5 or less, more preferably 4.0 or less, even more preferably 3.8 or less, still more preferably 3.2 or less, yet still more preferably 3.1 or less, yet even more preferably 3.0 or less, and particularly preferably 2.95 or less.

A polyimide precursor contained in LTC9320 E07, manufactured by FUJIFILM Corporation, is known as a commercially available product of the photosensitive resin composition containing a polyimide precursor, and a mixture obtained by mixing the composition with a surfactant can also be used.

<<<<Polyimide>>>>

The polyimide used in the invention is not particularly limited as long as it is a polymer compound having an imide ring. The polyimide is preferably a compound represented by Formula (4), and more preferably a compound represented by Formula (4) and having a polymerizable group.

Formula (4)

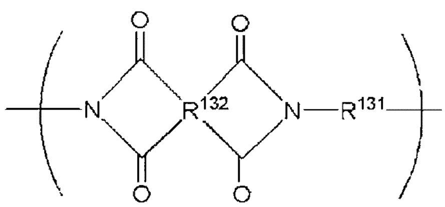

(4)

In Formula (4), $R^{131}$ represents a divalent organic group, and $R^{132}$ represents a tetravalent organic group.

In a case where a polymerizable group is contained, the polymerizable group may be positioned at at least one of $R^{131}$ or $R^{132}$, or at a terminal of the polyimide as shown in Formula (4-1) or (4-2).

Formula (4-1)

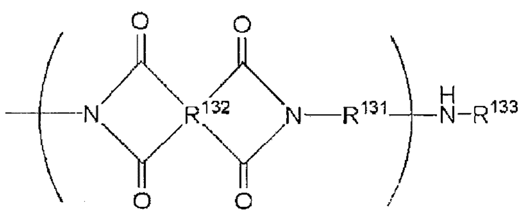

In Formula (4-1), $R^{133}$ represents a polymerizable group, and other groups have the same meanings as in Formula (4).

Formula (4-2)

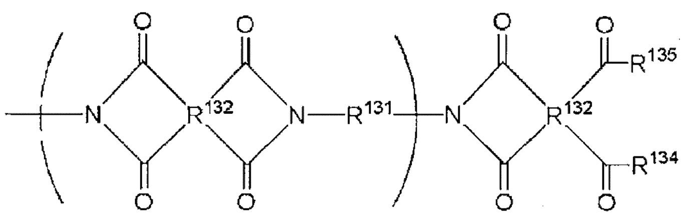

At least one of $R^{134}$ or $R^{135}$ represents a polymerizable group, and the other represents an organic group. Other groups have the same meanings as in Formula (4).

The polymerizable group has the same meaning as that for the polymerizable group of the polyimide precursor or the like.

$R^{131}$ represents a divalent organic group. Examples of the divalent organic group are the same as those exemplified above for $R^{111}$ in Formula (2), and the preferable ranges thereof are the same as those of $R^{111}$.

Examples of $R^{131}$ include a diamine residue remaining after removal of an amino group of a diamine. Examples of the diamine include an aliphatic diamine, a cycloaliphatic diamine, and an aromatic diamine. Specific examples thereof include examples of $R^{111}$ in Formula (2) in the polyimide precursor.

$R^{131}$ is preferably a diamine residue having at least two alkylene glycol units in a main chain from the viewpoint of more effectively suppressing the occurrence of warpage during baking. A diamine residue containing two or more ethylene glycol chain(s) and/or propylene glycol chain(s) in total in a molecule is more preferable, and a diamine residue containing no aromatic ring is even more preferable.

Examples of the diamine containing two or more ethylene glycol chain(s) and/or propylene glycol chain(s) in total in a molecule include, but are not limited to, JEFFAMINE (registered trademark) KH-511, JEFFAMINE (registered trademark) ED-600, JEFFAMINE (registered trademark) ED-900, JEFFAMINE (registered trademark) ED-2003, JEFFAMINE (registered trademark) EDR-148, JEFFAMINE (registered trademark) EDR-176, JEFFAMINE (registered trademark) D-200, JEFFAMINE (registered trademark) D-400, JEFFAMINE (registered trademark) D-2000, and JEFFAMINE (registered trademark) D-4000 (which are all trade names, manufactured by HUNTSMAN Corporation), 1-(2-(2-(2-aminopropoxy)ethoxy)propoxy)propane-2-amine, and 1-(1-(1-(2-aminopropoxy)propane-2-yl)oxy)propane-2-amine.

$R^{132}$ represents a tetravalent organic group. Examples of the tetravalent organic group are the same as those exemplified above for $R^{115}$ in Formula (2), and the preferable ranges thereof are the same as those of $R^{115}$.

For example, four bonding moieties of the tetravalent organic group exemplified as $R^{115}$ are bonded to four -C(=O)- moieties in Formula (4) to form the following fused ring.

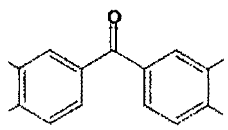

Examples of $R^{132}$ also include a tetracarboxylic acid residue remaining after removal of an acid anhydride group from a tetracarboxylic dianhydride. Specific examples thereof include examples of $R^{115}$ in Formula (2) in the polyimide precursor. From the viewpoint of hardness of a cured film, $R^{132}$ is preferably an aromatic diamine residue having 1 to 4 aromatic rings.

The polyimide preferably contains an OH group at at least one of $R^{131}$ or $R^{132}$. More specifically, preferable examples of $R^{131}$ include 2,2-bis(3-hydroxy-4-aminophenyl)propane, 2,2-bis(3-hydroxy-4-aminophenyl)hexafluoropropane, 2,2-bis(3-amino-4-hydroxyphenyl)propane, 2,2-bis(3-amino-4-hydroxyphenyl)hexafluoropropane, and the above (DA-1) to (DA-18), and preferable examples of $R^{132}$ include the above (DAA-1) to (DAA-5).

The polyimide preferably has a fluorine atom in the structural unit. The fluorine atom content in the polyimide is preferably 10 mass% or greater, and more preferably 20 mass% or less.

In order to improve the storage stability of the photosensitive resin composition, the main chain terminal of the polyimide is preferably sealed with a terminal sealing agent such as a monoamine, an acid anhydride, a monocarboxylic acid, a monoacid chloride compound, or a monoactive ester compound. Among these, a monoamine is more preferably used, and preferable examples of the monoamine compound include aniline, 2-ethynylaniline, 3-ethynylaniline, 4-ethynylaniline, 5-amino-8-hydroxyquinoline, 1-hydroxy-7-aminonaphthalene, 1-hydroxy-6-aminonaphthalene, 1-hydroxy-5-aminonaphthalene, 1-hydroxy-4-aminonaphthalene, 2-hydroxy-7-aminonaphthalene, 2-hydroxy-6-aminonaphthalene, 2-hydroxy-5-aminonaphthalene, 1-carboxy-7-aminonaphthalene, 1-carboxy-6-aminonaphthalene, 1-carboxy-5-aminonaphthalene, 2-carboxy-7-aminonaphthalene, 2-carboxy-6-aminonaphthalene, 2-carboxy-5-aminonaphthalene, 2-aminobenzoic acid, 3-aminobenzoic acid, 4-aminobenzoic acid, 4-aminosalicylic acid, 5-aminosalicylic acid, 6-aminosalicylic acid, 2-aminobenzenesulfonic acid, 3-aminobenzenesulfonic acid, 4-aminobenzenesulfonic acid, 3-amino-4,6-dihydroxypyrimidine, 2-aminophenol, 3-aminophenol, 4-aminophenol, 2-aminothiophenol, 3-aminothiophenol, and 4-aminothiophenol. Two or more of these monoamines may be used, or a plurality of different terminal groups may be introduced by reacting a plurality of terminal sealing agents.

The imidization ratio of the polyimide is preferably 85% or greater, and more preferably 90% or greater. In a case where the imidization ratio is 85% or greater, film shrinkage accompanying ring closure occurring when imidization occurs by heating is reduced, and the occurrence of warpage can be suppressed.

The polyimide may contain two or more different types of repeating units represented by Formula (X) containing

$R^{133}$ or $R^{134}$, in addition to one type of repeating structural unit represented by Formula (4) based on $R^{131}$ or $R^{132}$. The polyimide may further contain other types of repeating structural units, in addition to the repeating unit represented by Formula (4).

The polyimide can be synthesized using, for example, a method of allowing a tetracarboxylic dianhydride to react with a diamine compound (partially substituted with a monoamine as a terminal sealing agent) at low temperatures, a method of allowing a tetracarboxylic dianhydride (partially substituted with an acid anhydride, a monoacid chloride compound, or a monoactive ester compound as a terminal sealing agent) to react with a diamine compound at low temperatures; a method including: obtaining a diester by a tetracarboxylic dianhydride and an alcohol; and allowing the diester to react with a diamine (partially substituted with a monoamine as a terminal sealing agent) in the presence of a condensing agent, a method including: obtaining a diester by a tetracarboxylic dianhydride and an alcohol; converting the remaining dicarboxylic acid into an acid chloride; obtaining a polyimide precursor using a method such as reacting with a diamine (partially substituted with a monoamine as a terminal sealing agent); and subjecting the polyimide precursor into complete imidization using a known imidization reaction method, or a method of partially introducing an imide structure by interrupting an imidization reaction during the course of the reaction or a method of partially introducing an imide structure by blending a completely imidized polymer and a polyimide precursor of the polymer.

Examples of commercially available polyimides include Durimide (registered trademark) 284 (manufactured by Fujifilm Corporation) and Matrimide5218 (manufactured by HUNTSMAN Corporation).

The weight-average molecular weight (Mw) of the polyimide is preferably from 5,000 to 70,000, more preferably 8,000 to 50,000, and particularly preferably 10,000 to 30,000. In a case where the weight-average molecular weight is 5,000 or greater, bending resistance of a film after curing can be improved. The weight-average molecular weight is more preferably 20,000 or greater in order to obtain a cured film having excellent mechanical characteristics. In addition, in a case where two or more types of polyimides are contained, the weight-average molecular weight of at least one type of polyimide is preferably within the above range.

<<<<Polybenzoxazole Precursor>>>>

The type and the like of the polybenzoxazole precursor are not particularly specified. For example, the description in paragraphs 0097 to 0107 in JP2016-027357A can be referred to, and the contents thereof are incorporated herein.

<<<<Polybenzoxazole>>>>

The polybenzoxazole is not particularly limited as long as it is a polymer compound having a benzoxazole ring. The polybenzoxazole is preferably a compound represented by Formula (X), and more preferably a compound represented by Formula (X) and having a polymerizable group.

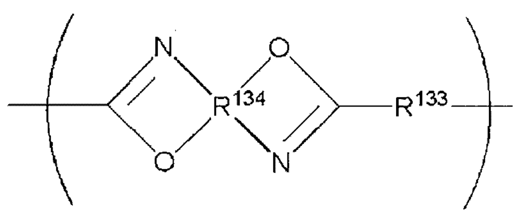

(X)

In Formula (X), $R^{133}$ represents a divalent organic group, and $R^{134}$ represents a tetravalent organic group.

In a case where a polymerizable group is contained, the polymerizable group may be positioned at at least one of $R^{133}$ or $R^{134}$, or at a terminal of the polybenzoxazole as shown in Formula (X-1) or (X-2).

Formula (X-1)

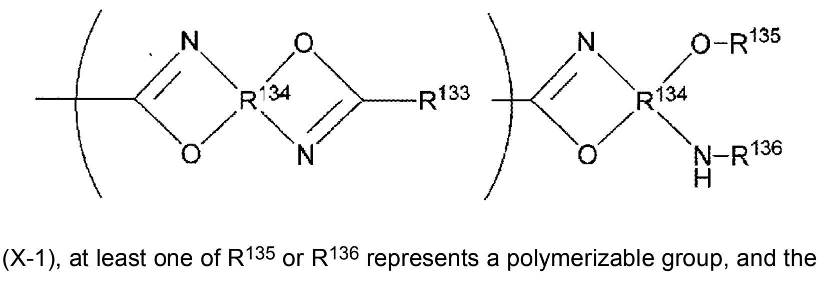

In Formula (X-1), at least one of $R^{135}$ or $R^{136}$ represents a polymerizable group, and the other represents an

organic group. Other groups have the same meanings as in Formula (X).

Formula (X-2)

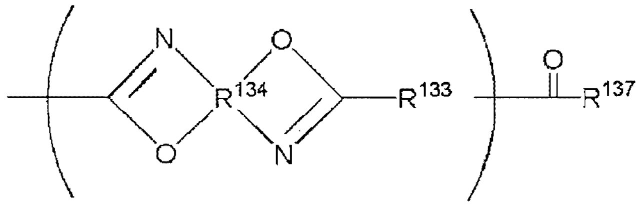

In Formula (X-2), $R^{137}$ represents a polymerizable group, and others are substituents. Other groups have the same meanings as in Formula (X).

The polymerizable group has the same meaning as that of the polymerizable group of the polyimide precursor.

$R^{133}$ represents a divalent organic group. Examples of the divalent organic group include an aliphatic group and an aromatic group. Specific examples thereof include examples of $R^{121}$ in Formula (3) in the polybenzoxazole precursor. In addition, preferable examples thereof are the same as those exemplified above for $R^{121}$.

$R^{134}$ represents a tetravalent organic group. Examples of the tetravalent organic group include examples of $R^{122}$ in Formula (3) in the polybenzoxazole precursor. In addition, preferable examples thereof are the same as those exemplified above for $R^{122}$.

For example, four bonding moieties of the tetravalent organic group exemplified as $R^{122}$ are bonded to a nitrogen atom and an oxygen atom in Formula (X) to form a fused ring. In this case, $R^{134}$ forms the following structure.

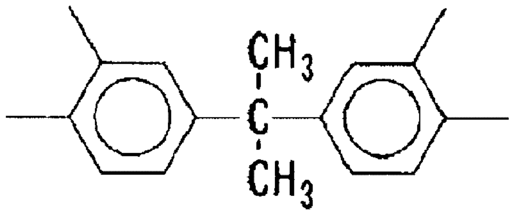

The oxazole conversion ratio of the polybenzoxazole is preferably 85% or greater, and more preferably 90% or greater. In a case where the oxazole conversion ratio is 85% or greater, film shrinkage based on ring closure occurring when oxazole conversion occurs by heating is reduced, and the occurrence of warpage can be effectively suppressed.

Regarding the repeating structural unit represented by Formula (X) in the polybenzoxazole, one type of repeating structural unit, or two or more types of repeating structural units may be contained. The polybenzoxazole may further contain other types of repeating structural units in addition to the repeating unit represented by Formula (X).

The polybenzoxazole is obtained as follows: for example, a bisaminophenol derivative is allowed to react with a compound selected from a dicarboxylic acid containing $R^{133}$, a dicarboxylic acid dichloride, and a dicarboxylic acid derivative to thereby obtain a polybenzoxazole precursor, and the resulting product is converted into an oxazole using a known oxazole conversion reaction method.

In a case where a dicarboxylic acid is used, an active ester type dicarboxylic acid derivative, which is preliminarily reacted with 1-hydroxy-1,2,3-benzotriazole or the like, may be used in order to increase the reaction yield or the like.

The weight-average molecular weight (Mw) of the polybenzoxazole is preferably 5,000 to 70,000, more preferably 8,000 to 50,000, and particularly preferably 10,000 to 30,000. In a case where the weight-average molecular weight is 5,000 or greater, bending resistance of a film after curing can be improved. The weight-average molecular weight is more preferably 20,000 or greater in order to obtain a cured film having excellent mechanical characteristics. In addition, in a case where two or more types of polybenzoxazoles are contained, the weight-average molecular weight of at least one type of polybenzoxazole is preferably within the above range.

<<<<Phenol Resin>>>>

Regarding the phenol resin, the description in paragraphs 0013 to 0070 in JP2015-036774A, particularly, the description in paragraphs 0013 to 0020 can be referred to, and the contents thereof are incorporated herein.

The photosensitive resin composition used in the invention may contain only one type of resin or two or more

types of resins. Two or more resins of the same type which have different types of structures may be contained.

The resin content in the photosensitive resin composition used in the invention is preferably 10 to 99 mass%, more preferably 50 to 98 mass%, and even more preferably 70 to 96 mass% of the resin pattern forming component, that is, the resin pattern.

<<<Polymerizable Compound>>>

The photosensitive resin composition preferably contains a polymerizable compound.

The polymerizable compound is a compound having a polymerizable group, and a known compound capable of undergoing a crosslinking reaction with radicals, acids, bases, and the like can be used. Examples of the polymerizable group include an epoxy group, an oxetanyl group, a group having an ethylenically unsaturated bond, a block isocyanate group, an alkoxymethyl group, a methylol group, and an amino group. Only one type of polymerizable compound, or two or more types of polymerizable compounds may be contained.

Examples of the polymerizable compound include monomers, oligomers, and mixtures thereof.

In the invention, a monomer type polymerizable compound (hereinafter also referred to as a polymerizable monomer) is a compound different from a polymer compound. The polymerizable monomer is typically a low-molecular compound, preferably with a molecular weight of 2,000 or less, more preferably 1,500 or less, and even more preferably 900 or less. The molecular weight of the polymerizable monomer is typically 100 or greater.

An oligomer type polymerizable compound is typically a polymer with a relatively low molecular weight, and is preferably a polymer in which 2 to 50 polymerizable monomers are bonded.

In the invention, the number of functional groups of the polymerizable compound means the number of polymerizable groups per molecule.

From the viewpoint of developability, the polymerizable compound preferably contains at least one type of bi- or higher functional polymerizable compound having two or more polymerizable groups, and more preferably contains at least one type of tri- or higher functional polymerizable compound.

In the invention, in view of improving the heat resistance by forming a three-dimensional crosslinked structure, the polymerizable compound preferably contains at least one type of tri- or higher functional polymerizable compound. It may alternatively be a mixture of a bi- or lower functional polymerizable compound and a tri- or higher functional polymerizable compound.

In the invention, examples of the polymerizable compound include a compound having an ethylenically unsaturated bond, a compound having a hydroxymethyl group, an alkoxymethyl group, or an acyloxymethyl group, an epoxy compound (a compound having an epoxy group), an oxetane compound (a compound having an oxetanyl group), and a benzoxazine compound (a compound having a benzoxazolyl group).

The polymerizable compound is preferably a photo-radical polymerizable monomer, and more preferably (meth)acrylate.

Regarding specific examples of the polymerizable compound, the description in paragraphs 0087 to 0132 in WO2015/199219A and the description in paragraphs 0029 and 0030 in WO2014/045434A can be referred to, and the contents thereof are incorporated herein.

From the viewpoints of good curability and heat resistance, the polymerizable compound content is preferably 1 to 50 mass% with respect to the resin pattern forming component in the photosensitive resin composition. The lower limit is more preferably 5 mass% or greater. The upper limit is more preferably 30 mass% or less. One type of polymerizable compound may be used independently, or two or more types of polymerizable compounds may be used as a mixture.

The mass ratio of the resin to the polymerizable compound (resin/polymerizable compound) is preferably 98/2 to 10/90, more preferably 95/5 to 30/70, and most preferably 90/10 to 50/50.

<<<Photopolymerization Initiator>>>

The photosensitive resin composition used in the invention may contain a photopolymerization initiator. Particularly, in a case where the photosensitive resin composition contains a photo-radical polymerization initiator, curing by radicals occurs in a case where the photosensitive resin composition is applied to a semiconductor wafer or the like to form a layer-like photosensitive resin composition, and then the layer is irradiated with light. Thus, it is possible to decrease the solubility in the light-irradiated portion. Accordingly, for example, in a case where the composition layer is exposed through a photomask having a pattern masking only an electrode portion, there is an advantage that it is possible to easily prepare a region whose solubility is different according to the pattern of the electrode.

The photopolymerization initiator is not particularly limited as long as it has an ability to initiate a polymerization reaction (crosslinking reaction) of a polymerizable compound, and can be appropriately selected from known photopolymerization initiators. For example, a photopolymerization initiator having photosensitivity to light from an ultraviolet region to a visible region is preferable. Also, the photopolymerization initiator may be an activator which causes any

action with a photoexcited sensitizer to produce an active radical.

The photopolymerization initiator preferably contains at least one type of compound having a molar light absorption coefficient of at least about 50 within a range of about 300 to 800 nm (preferably 330 to 500 nm). The molar light absorption coefficient of the compound can be measured using a known method. Specifically, the molar light absorption coefficient is preferably measured, for example, by an ultraviolet and visible spectrophotometer (Cary-5 spectrophotometer, manufactured by Varian Medical Systems, Inc.) using an ethyl acetate solvent at a concentration of 0.01 g/L.

As the photopolymerization initiator, a known compound can be used without limitation. Examples thereof include a halogenated hydrocarbon derivative (for example, a compound having a triazine skeleton, a compound having an oxadiazole skeleton, or a compound having a trihalomethyl group), an acylphosphine compound such as an acylphosphine oxide, a hexaarylbiimidazole, an oxime compound such as an oxime derivative, an organic peroxide, a thio compound, a ketone compound, an aromatic onium salt, a ketoxime ether, an aminoacetophenone compound, a hydroxyacetophenone, an azo-based compound, an azide compound, a metallocene compound, an organic boron compound, and an iron-arene complex. An oxime compound and a metallocene compound are preferable, and an oxime compound is more preferable.

As specific examples of the oxime compound, compounds described in JP2001-233842A, compounds described in JP2000-080068A, and compounds described in JP2006-342166A can be used.

Preferable examples the oxime compound include compounds having any one of the following structures, 3-benzoyloxyiminobutan-2-one, 3-acetoxyiminobutan-2-one, 3-propionyloxyiminobutan-2-one, 2-acetoxyiminopentan-3-one, 2-acetoxyimino-1-phenylpropan-1-one, 2-benzoyloxyimino-1-phenylpropan-1-one, 3-(4-toluenesulfonyloxy)iminobutan-2-one, and 2-ethoxycarbonyloxyimino-1-phenylpropan-1-one.

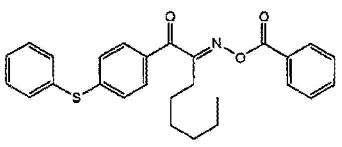
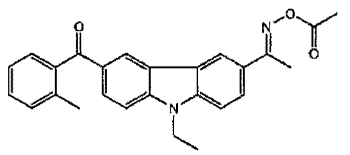
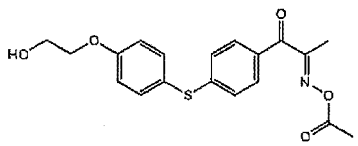
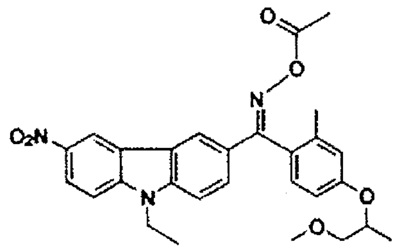

Examples of the oxime compound include compounds described in J. C. S. Perkin II (1979) pp. 1653 to 1660, J. C. S. Perkin II (1979) pp. 156 to 162, or Journal of Photopolymer Science and Technology (1995) pp. 202 to 232, and compounds described in JP2000-066385A, JP2000-080068A, JP2004-534797A, JP2006-342166A, or WO2015/036910A.

IRGACURE OXE 01, IRGACURE OXE 02, IRGACURE OXE 03, and IRGACURE OXE 04 (all manufactured by BASF SE), and ADEKAOPTOMER N-1919 (manufactured by ADEKA Corporation, photopolymerization initiator 2 described in JP2012-014052A) are also preferably used as commercially available products. In addition, TR-PBG-304 (manufactured by Changzhou Tronly New Electronic Materials Co., Ltd.), ADEKA ARKLS NCI-831, and ADEKA ARKLS NCI-930 (manufactured by ADEKA Corporation) can also be used. DFI-091 (manufactured by DAITO CHEMIX Co., Ltd.) can also be used.

In addition, compounds described in JP2009-242469A having an unsaturated bond at a specific site of an oxime compound can also be preferably used.

It is also possible to use an oxime compound having a fluorine atom. Specific examples of the oxime compound include compounds described in JP2010-262028A, compounds 24 and 36 to 40 described in paragraphs 0345 to 0348 in JP2014-500852A, and a compound (C-3) described in paragraph 0101 in JP2013-164471A.

As specific examples of the photopolymerization initiator, the description in paragraphs 0141 to 0150 in WO2015/199219A and the description in paragraphs 0165 to 0182 in JP2016-027357A can be referred to, and the contents thereof are incorporated herein.

In a case where the photosensitive resin composition contains a photopolymerization initiator, the content of the photopolymerization initiator is preferably 0.1 to 30 mass%, more preferably 0.1 to 20 mass%, and even more preferably 0.1 to 10 mass% with respect to the resin pattern forming component in the photosensitive resin composition. In addition, the photopolymerization initiator is preferably contained in an amount of 1 to 20 parts by mass, and more preferably 3 to 10 parts by mass with respect to 100 parts by mass of the polymerizable compound.

Only one type of photopolymerization initiator, or two or more types of photopolymerization initiators may be contained. In a case where two or more types of photopolymerization initiators are contained, the total content thereof

is preferably within the above range.

<<<Surfactant>>>

The photosensitive resin composition contains a surfactant. The surfactant is a compound having a hydrophobic group (including a lipophilic group) and a hydrophilic group. In the invention, the hydrophobic group of the surfactant acts on the temporary adhesive film, and the hydrophilic group acts on the resin film or the resin pattern, thereby effectively suppressing mixing of the temporary adhesive film and the resin film or the resin pattern.

Examples of the hydrophobic group include a halogen atom, an ester group, an aryl group, an alkyl group, and an alkoxy group. The halogen atom is preferably a fluorine atom. A phenyl group, an alkyl group, and an alkoxy group, which have been substituted with a fluorine atom, are preferable.

Examples of the hydrophilic group include a hydroxyl group, a carboxyl group, an aldehyde group, an amino group, a nitro group, a sulfo group, and a thiol group. A hydroxyl group and a carboxyl group are preferable, and a hydroxyl group is more preferable.

As the surfactant, various surfactants such as a fluorine-based surfactant, a nonionic surfactant, a cationic surfactant, an anionic surfactant, a silicone-based surfactant, and a zwitterionic surfactant can be used.

The fluorine content of a fluorine-based surfactant is preferably 3 to 40 mass%, more preferably 5 to 30 mass%, and particularly preferably 7 to 25 mass%. A fluorine-based surfactant having a fluorine content within the above range is effectively used in view of thickness uniformity of a coating film and liquid saving, and also has good solvent solubility.

Examples of the fluorine-based surfactant include MEGAFACE F-171, MEGAFACE F-172, MEGAFACE F-173, MEGAFACE F-176, MEGAFACE F-177, MEGAFACE F-141, MEGAFACE F-142, MEGAFACE F-143, MEGAFACE F-144, MEGAFACE F-410, MEGAFACE F-437, MEGAFACE F-444, MEGAFACE F-475, MEGAFACE F-479, MEGAFACE F-482, MEGAFACE F-553, MEGAFACE F-554, MEGAFACE F-556, MEGAFACE F-569, MEGAFACE F-575, MEGAFACE F-780, and MEGAFACE F-781 (all manufactured by DIC Corporation), FLUORAD FC430, FLUORAD FC431, FLUORAD FC171 (all manufactured by SUMITOMO 3M LTD.), SURFLON S-382, SURFLON SC-101, SURFLON SC-103, SURFLON SC-104, SURFLON SC-105, SURFLON SC1068, SURFLON SC-381, SURFLON SC-383, SURFLON S393, and SURFLON KH-40 (all manufactured by AGC. Inc.), PF636, PF656, PF6320, PF6520, and PF7002 (all manufactured by OMNOVA Solutions Inc.).

A block polymer can also be used as a fluorine-based surfactant, and specific examples thereof include compounds described in JP2011-089090A.

Examples of the fluorine-based surfactant used in the invention also include the following compound.

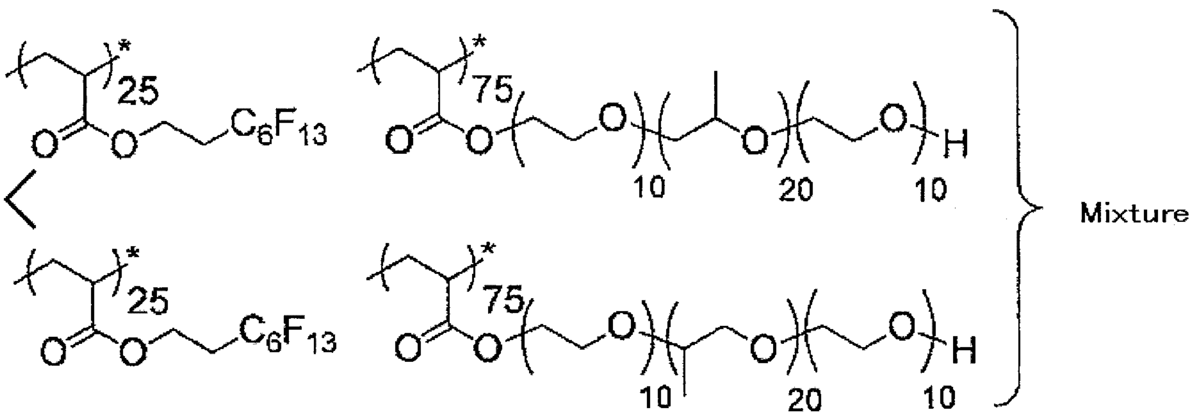


The weight-average molecular weight of the above compound is, for example, 14,000.

The anionic surfactant is not particularly limited, and examples thereof include fatty acid salts, abietic acid salts, hydroxyalkanesulfonic acid salts, alkanesulfonic acid salts, dialkylsulfosuccinic acid salts, linear alkylbenzenesulfonic acid salts, branched alkylbenzenesulfonic acid salts, alkylnaphthalenesulfonic acid salts, alkyldiphenylether (di)sulfonic acid salts, alkylphenoxy polyoxyethylene alkyl sulfonic acid salts, polyoxyethylene alkylsulfophenyl ether salts, N-alkyl-N-oleyltaurine sodium salts, N-alkylsulfosuccinic acid monoamide disodium salts, petroleum sulfonic acid salts, sulfated castor oil, sulfated beef tallow oil, sulfate ester salts of fatty acid alkyl esters, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styryl phenyl ether sulfate ester salts, alkyl phosphate ester salts, polyoxyethylene alkyl ether phosphate ester salts, polyoxyethylene alkyl phenyl ether phosphate ester salts, partially saponified products of styrene-maleic anhydride copolymers, partially saponified products of olefin-maleic anhydride copolymers, and naphthalene sulfonate formalin condensates.

Among these, alkylbenzenesulfonic acid salts, alkylnaphthalenesulfonic acid salts, and alkyldiphenylether (di)sulfonic acid salts are particularly preferably used. Examples of commercially available products thereof include W004, W005, and W017 (manufactured by Yusho Co., Ltd.).

The cationic surfactant is not particularly limited, and a cationic surfactant which has been known in the past can be used. Examples thereof include alkylamine salts, quaternary ammonium salts, alkylimidazolinium salts, polyoxyethylene alkylamine salts, and polyethylene polyamine derivatives. Examples of commercially available products thereof include a phthalocyanine derivative (trade name: EFKA-745, manufactured by Morishita & Co., Ltd.), an organosiloxane polymer KP341 (manufactured by Shin-Etsu Chemical Co., Ltd.), (meth)acrylate-based (co)polymers POLYFLOW No.75, No.90, and No.95 (manufactured by KYOEISHA CHEMICAL Co., LTD.), and W001 (manufactured by Yusho Co., Ltd.).

The nonionic surfactant is not particularly limited, and examples thereof include a polyethylene glycol type higher alcohol ethylene oxide adduct, an alkylphenol ethylene oxide adduct, an alkyl naphthol ethylene oxide adduct, a phenol ethylene oxide adduct, a naphthol ethylene oxide adduct, a fatty acid ethylene oxide adduct, a polyhydric alcohol fatty acid ester ethylene oxide adduct, a higher alkylamine ethylene oxide adduct, a fatty acid amide ethylene oxide adduct, an ethylene oxide adduct of an oil or fat, a polypropylene glycol ethylene oxide adduct, a dimethylsiloxane-ethylene oxide block copolymer, a dimethylsiloxane-(propylene oxide-ethylene oxide) block copolymer, a polyhydric alcohol type glycerol fatty acid ester, a pentaerythritol fatty acid ester, sorbitol and sorbitan fatty acid esters, a sucrose fatty acid ester, a polyhydric alcohol alkyl ether, and an alkanolamine fatty acid amide. Among these, those having an aromatic ring and an ethylene oxide chain are preferable, and an alkyl-substituted or unsubstituted phenol ethylene oxide adduct and an alkyl-substituted or unsubstituted naphthol ethylene oxide adduct are more preferable. Examples of commercially available products thereof include PLURONIC L10, L31, L61, L62, 10R5, 17R2, and 25R2 and TETRONIC 304, 701, 704, 901, 904, and 150R1 manufactured by BASF SE, SOLSPERSE 20000 manufactured by Lubrizol Corporation, PIONIN D-6112-W manufactured by Takemoto Oil & Fat Co., Ltd., and NCW-101, NCW-1001, and NCW-1002 manufactured by FUJIFILM Wako Pure Chemical Corporation.

Examples of the silicone-based surfactant include "Toray Silicone DC3PA", "Toray Silicone SH7PA", "Toray Silicone DC11PA", "Toray Silicone SH21PA", "Toray Silicone SH28PA", "Toray Silicone SH29PA", "Toray Silicone SH30PA", and "Toray Silicone SH8400" manufactured by Dow Chemical Company, "TSF-4440", "TSF-4300", "TSF-4445", "TSF-4460", and "TSF-4452" manufactured by Momentive Performance Materials Inc., "KP341", "KF6001", and "KF6002" manufactured by Shin-Etsu Chemical Co., Ltd., and "BYK307", "BYK323", and "BYK330" manufactured by BYK Additives & Instruments.

The zwitterionic surfactant is not particularly limited, and examples thereof include an amine oxide type such as alkyldimethylamine oxide, a betaine type such as alkylbetaine, and an amino acid type such as alkylamino fatty acid sodium salt. Particularly, an alkyldimethylamine oxide which may have a substituent, an alkylcarboxybetaine which may have a substituent, an amine oxide which may have a substituent, and an alkylsulfobetaine which may have a substituent are preferably used.

Specifically, a compound represented by Formula (2) in paragraph 0256 in JP2008-203359A, compounds represented by formulae (I), (II) and (VI) in paragraph 0028 in JP2008-276166A, and compounds shown in paragraphs 0022 to 0029 in JP2009-047927A can be used, and the contents thereof are incorporated herein.

The surfactant content is preferably greater than 0 mass% and not greater than 1.0 mass% of the resin film forming component in the photosensitive resin composition, that is, the resin pattern. The lower limit value of the surfactant content is more preferably 0.001 mass% or greater, even more preferably 0.01 mass% or greater, and still more preferably 0.06 mass% or greater. The upper limit value of the surfactant content is more preferably 0.8 mass% or less, and even more preferably 0.5 mass% or less.

<<<Solvent>>>

The photosensitive resin composition used in the invention usually contains a solvent. In a case where a solvent is contained, it is possible to apply the resin component and the like contained in the photosensitive resin composition in the form of a layer. Examples of the solvent are as follows.

Preferable examples of the solvent include esters such as ethyl acetate, n-butyl acetate, isobutyl acetate, amyl formate, isoamyl acetate, butyl propionate, isopropyl butyrate, ethyl butyrate, butyl butyrate, methyl lactate, ethyl lactate, γ-butyrolactone, ε-caprolactone, δ-valerolactone, alkyl alkyloxyacetate (example: methyl alkyloxyacetate, ethyl alkyloxyacetate, and butyl alkyloxyacetate (for example, methyl methoxyacetate, ethyl methoxyacetate, butyl methoxyacetate, methyl ethoxyacetate, and ethyl ethoxyacetate)), alkyl 3-alkyloxypropionate esters (example: methyl 3-alkyloxypropionate and ethyl 3-alkyloxypropionate (for example, methyl 3-methoxypropionate, ethyl 3-methoxypropionate, methyl 3-ethoxypropionate, and ethyl 3-ethoxypropionate)), alkyl 2-alkyloxypropionate esters (example: methyl 2-alkyloxypropionate, ethyl 2-alkyloxypropionate, and propyl 2-alkyloxypropionate (for example, methyl 2-methoxypropionate, ethyl 2-methoxypropionate, propyl 2-methoxypropionate, methyl 2-ethoxypropionate, and ethyl 2-ethoxypropionate)), methyl 2-alkyloxy-2-methyl propionate, ethyl 2-alkyloxy-2-methyl propionate (for example, methyl 2-methoxy-2-methyl propionate and ethyl 2-ethoxy-2-methyl propionate), methyl pyruvate, ethyl pyruvate, propyl pyruvate, methyl acetoacetate, ethyl acetoacetate, methyl 2-oxobutanoate, and ethyl 2-oxobutanoate, ethers such as diethylene glycol dimethyl ether, tetrahydrofuran, ethylene glycol monomethyl ether, ethylene glycol monoethyl ether, methyl cellosolve acetate, ethyl cellosolve acetate, diethylene glycol monomethyl ether, diethylene glycol monoethyl ether, diethylene glycol monobutyl ether, propylene glycol monomethyl ether, propylene glycol monomethyl ether acetate, propylene glycol monoethyl ether acetate, and propylene glycol monopropyl ether acetate, ketones such as methyl ethyl ketone, cyclohexanone, cyclopentanone, 2-heptanone, 3-heptanone, and N-methyl-2-pyrrolidone, aromatic hydrocarbons such as toluene, xylene, anisole, and limonene, and sulfoxides such as dimethyl sulfoxide.

In the invention, particularly, the SP value (solubility parameter) is preferably 19.0 to 30.0, and more preferably 19.0 to 27.0. In addition, the boiling point is preferably 120°C to 270°C, and more preferably 160°C to 260°C. Examples of the solvent include N-methyl-2-pyrrolidone, cyclohexanone, cyclopentanone, γ-butyrolactone, N-acetylmorpholine, and N-formylmorpholine.

The solvents are also preferably used as a mixture of two or more types from the viewpoint of an improvement of a coating surface state and the like. Among these, a mixed solution of two or more types selected from methyl 3-ethoxypropionate, ethyl 3-ethoxypropionate, ethyl cellosolve acetate, ethyl lactate, diethylene glycol dimethyl ether, butyl acetate, methyl 3-methoxypropionate, 2-heptanone, cyclohexanone, cyclopentanone, γ-butyrolactone, dimethyl sulfoxide, ethyl carbitol acetate, butyl carbitol acetate, propylene glycol methyl ether, and propylene glycol methyl ether acetate is preferable. Dimethyl sulfoxide and γ-butyrolactone are particularly preferably used in combination.

Particularly, in a case where the resin pattern contains a polyimide resin, the solvent is particularly preferable.

In a case where the photosensitive composition has a solvent, the solvent content is set such that the amount of the resin pattern forming component is preferably 5 to 80 mass%, more preferably 5 to 70 mass%, and particularly preferably 10 to 60 mass% from the viewpoint of coatability. The solvent content may be adjusted according to a desired film thickness and a coating method.

Only one type of solvent, or two or more types of solvents may be contained. In a case where two or more types of solvents are contained, the total content thereof is preferably within the above range.

<Temporary Adhesive Film and Resin Pattern>

In the invention, a mass ratio O/C of an oxygen atom to a carbon atom contained in the temporary adhesive film is 0 to 0.05, and more preferably 0.005 to 0.015. In addition, a mass ratio O/C of an oxygen atom to a carbon atom contained in the resin film (resin pattern) is 0.20 to 0.40, and more preferably 0.25 to 0.35. Due to such a configuration, it is possible to more effectively suppress mixing of the temporary adhesive film and the resin pattern.

The mass ratio between an oxygen atom and a carbon atom contained in the temporary adhesive film and the mass ratio between an oxygen atom and a carbon atom contained in the temporary adhesive film forming component contained in the composition for temporary adhesion are the same, and the mass ratio between an oxygen atom and a carbon atom contained in the resin film and the mass ratio between an oxygen atom and a carbon atom contained in the resin film forming component contained in the photosensitive resin composition are the same.

The difference between the mass ratio O/C between an oxygen atom and a carbon atom contained in the resin film and the mass ratio O/C between an oxygen atom and a carbon atom contained in the temporary adhesive film is preferably 0.15 to 0.40, even more preferably 0.20 to 0.35, and still more preferably 0.29 to 0.31.

In the invention, the interface between the temporary adhesive film and the resin pattern is preferably a mirror surface.

<Metal>

The laminate according to the embodiment of the invention contains a metal. The metal is preferably provided between the resin patterns and/or on the surface of the resin pattern. As will be described later, in the invention, a step of forming a resin pattern and a step of applying a metal are preferably alternately repeated, and the metal formed as above serves as a wire (particularly, rewiring) or an electrode.

The metal may be formed of only one type of metal or two or more types of metals. Examples of the metal forming the metal include copper, aluminum, nickel, vanadium, titanium, chromium, cobalt, gold, and tungsten, and copper is preferable.

The method of forming a metal layer will be described later.

<Chip>

The laminate according to the embodiment of the invention preferably further has a chip which is in contact

with the metal. For example, by providing a semiconductor chip, the laminate can be used as a semiconductor device.

Method of Manufacturing Semiconductor Device

The laminate according to the embodiment of the invention is used in, for example, manufacturing of a semiconductor device. The invention discloses a method of manufacturing a semiconductor device including: a step of applying a photosensitive resin composition containing a resin and a surfactant to a surface of a temporary adhesive film in the form of a layer; a step of forming a resin pattern by exposing and developing the layer-like photosensitive resin composition; and a step of applying a metal at least between the resin patterns.

Details of the temporary adhesive film, composition for temporary adhesion, resin pattern, photosensitive resin composition, metal, and the like in the method of manufacturing a semiconductor device according to the embodiment of the invention have the same meanings as those described in Laminate unless otherwise specified.

<Step of Forming Temporary Adhesive Film>

The temporary adhesive film is preferably formed using the composition for temporary adhesion.

In the formation of the temporary adhesive film, first, a composition for temporary adhesion is preferably applied to a support in the form of a layer. As a method of applying the composition in the form of a layer, a spin coating method, a spray method, a slit coating method, a roller coating method, a flow coating method, a doctor coating method, a dipping method, or the like, which have been known in the past can be used.

Next, in general, the composition for temporary adhesion preferably contains a solvent, and thus the solvent is volatilized by heating. The heating temperature is preferably higher than the boiling point of the solvent, more preferably 110°C or higher, even more preferably 110°C to 250°C, and still more preferably 120°C to 200°C. The heating may be performed at two or more different temperatures.

In this manner, for example, a temporary adhesive film 2 is formed on a support 1 as shown in (1) in Fig. 2.

<Step of Applying Photosensitive Resin Composition in Form of Layer>

The method of manufacturing a semiconductor device according to the embodiment of the invention includes a step of applying a photosensitive resin composition containing a resin and a surfactant to a surface of the temporary adhesive film in the form of a layer.

Coating is preferable as means for applying the photosensitive resin composition to the surface of the temporary adhesive film.

Specifically, examples of the means for application include a dip coating method, an air knife coating method, a curtain coating method, a wire bar coating method, a gravure coating method, an extrusion coating method, a spray coating method, a spin coating method, a slit coating method, and an ink jet method. From the viewpoint of thickness uniformity of the photosensitive resin composition layer, a spin coating method, a slit coating method, a spray coating method, and an ink jet method are more preferable methods. A desired resin film can be obtained by appropriately adjusting the concentration of solid contents and coating conditions according to the method. In addition, the coating method can also be appropriately selected according to the shape of the support or the temporary adhesive film provided on the surface of the support. In a case where the support is a circular support, a spin coating method, a spray coating method, an ink jet method, or the like is preferable, and in a case where the support is a rectangular support, a slit coating method, a spray coating method, an inkjet method, or the like is preferable. In a spin coating method, for example, the composition can be applied for about 10 seconds to 1 minute at a rotation speed of 500 to 2,000 rpm.

Regarding the thickness of the photosensitive resin composition layer, the photosensitive resin composition is applied such that the film thickness (thickness of the resin pattern) after development by exposure is preferably 0.1 to 100 μm, and more preferably 1 to 50 μm.

Details of the photosensitive resin composition have the same meanings as those described above, and the preferable ranges thereof are the same as described above.

<Filtration Step>

The method of manufacturing a semiconductor device according to the embodiment of the invention may include a step of filtering the photosensitive resin composition before application of the photosensitive resin composition to the surface of the temporary adhesive film. The filtration is preferably performed using a filter. The filter pore size is preferably 1 μm or less, more preferably 0.5 μm or less, and even more preferably 0.1 μm or less. Regarding the material of the filter, filters made of polytetrafluoroethylene, polyethylene, or nylon are preferable. As the filter, a filter pre-washed with an organic solvent may be used. In the filtering step, a plurality of types of filters connected in series or in parallel may

be used. In a case where a plurality of types of filters are used, filters different in at least one of pore size or material may be used in combination. In addition, various materials may be filtered a plurality of times, and the step of performing filtration a plurality of times may be provided as a circulating filtration step. The filtration may be performed under pressure, and the pressure to be applied is preferably 0.05 MPa or greater and 0.3 MPa or less.

Other than filtration using a filter, an adsorbing material may be used to remove impurities, or filtering and an adsorbing material may be used in combination. A known adsorbing material can be used as the adsorbing material, and for example, inorganic adsorbing materials such as silica gel and zeolite, or organic adsorbing materials such as activated carbon can be used.

<Drying Step>

The method of manufacturing a semiconductor device according to the embodiment of the invention may include a step of drying the solvent after the formation of the photosensitive resin composition layer. The drying temperature is preferably 50°C to 150°C, more preferably 70°C to 130°C, and most preferably 90°C to 110°C. The drying time is, for example, 30 seconds to 20 minutes, preferably 1 minute to 10 minutes, and most preferably 3 minutes to 7 minutes.

In this manner, for example, a resin film 4 is formed on the surface of the temporary adhesive film 2 as shown in (1) in Fig. 2.

<Step of Forming Resin Pattern by Exposing and Developing Layer-Like Photosensitive Resin Composition>

The method of manufacturing a semiconductor device according to the embodiment of the invention includes a step of forming a resin pattern by exposing and developing the layer-like photosensitive resin composition. For example, as shown in (2) in Fig. 2, the resin pattern 4 is formed on the surface of the temporary adhesive film 2.

Exposure is not particularly limited as long as the photosensitive resin composition can be cured. Irradiation is preferably performed at 100 to 10,000 $mJ/cm^2$ in terms of exposure energy at a wavelength of 365 nm, and more preferably 200 to 8,000 $mJ/cm^2$.

The exposure wavelength can be appropriately determined within a range of 190 to 1,000 nm, and is preferably 240 to 550 nm.

In the method of manufacturing a semiconductor device according to the embodiment of the invention, a development treatment is performed on the exposed photosensitive resin composition layer. As described above, the development treatment may be a negative development treatment or a positive development treatment, and can be appropriately determined according to the type of the photosensitive resin composition. In the invention, a negative development treatment is preferable. A portion which is not exposed (unexposed portion) is removed by performing negative development. The developing method is not particularly limited as long as a desired pattern can be formed, and for example, a developing method such as paddle development, spray development, dipping development, or ultrasonic development can be employed.

Development is performed using a developer. The developer preferably contains a solvent in which a solubility of the temporary adhesive film at 25°C is 1 mass% or less. More preferably, the solubility is 0.5 mass% or less. The lower limit value is preferably as low as possible, and may be 0 mass%. In the invention, 90 mass% of the solvent contained in the developer preferably satisfies the solubility of the temporary adhesive film, and more preferably, 95 mass% or greater of the solvent satisfies the solubility. In the developer, a solvent which dissolves the surfactant contained in the photosensitive resin composition is preferably selected. This is because the development may not be satisfactorily performed in a case where a developer which cannot dissolve the surfactant segregating on the surface.

Particularly, in the invention, the developer preferably contains cyclopentanone, and more preferably, 95 mass% or greater of the developer is formed of cyclopentanone.

Examples of the solvent contained in the developer are as follows.

Preferable examples of the solvent include esters such as ethyl acetate, n-butyl acetate, isobutyl acetate, amyl formate, isoamyl acetate, butyl propionate, isopropyl butyrate, ethyl butyrate, butyl butyrate, methyl lactate, ethyl lactate, γ-butyrolactone, ε-caprolactone, δ-valerolactone, alkyl alkyloxyacetate (example: methyl alkyloxyacetate, ethyl alkyloxyacetate, and butyl alkyloxyacetate (for example, methyl methoxyacetate, ethyl methoxyacetate, butyl methoxyacetate, methyl ethoxyacetate, and ethyl ethoxyacetate)), alkyl 3-alkyloxypropionate esters (example: methyl 3-alkyloxypropionate and ethyl 3-alkyloxypropionate (for example, methyl 3-methoxypropionate, ethyl 3-methoxypropionate, methyl 3-ethoxypropionate, and ethyl 3-ethoxypropionate)), alkyl 2-alkyloxypropionate esters (example: methyl 2-alkyloxypropionate, ethyl 2-alkyloxypropionate, and propyl 2-alkyloxypropionate (for example, methyl 2-methoxypropionate, ethyl 2-methoxypropionate, propyl 2-methoxypropionate, methyl 2-ethoxypropionate, and ethyl 2-ethoxypropionate)), methyl 2-alkyloxy-2-methyl propionate, ethyl 2-alkyloxy-2-methyl propionate (for example, methyl 2-methoxy-2-methyl propionate and ethyl 2-ethoxy-2-methyl propionate), methyl pyruvate, ethyl pyruvate, propyl pyruvate, methyl acetoacetate, ethyl acetoacetate, methyl 2-oxobutanoate, and ethyl 2-oxobutanoate, ethers such as diethylene glycol dimethyl ether, tetrahydrofuran, ethylene glycol monomethyl ether, ethylene glycol monoethyl ether, methyl cellosolve acetate, ethyl cellosolve acetate, diethylene glycol monomethyl ether, diethylene glycol monoethyl ether, diethylene glycol monobutyl ether, propylene glycol monomethyl ether, propylene glycol monomethyl ether acetate, propylene glycol monoethyl ether acetate, and propylene glycol monopropyl ether acetate, ketones such as methyl ethyl ketone, cyclohexanone, cyclopentanone, 2-heptanone, 3-heptanone, and N-methyl-2-pyrrolidone, aromatic hydrocarbons such as toluene, xylene, anisole, and limonene, and sulfoxides such as dimethyl sulfoxide. Among these, methyl 3-ethoxypropionate, ethyl 3-ethoxypropionate, ethyl cellosolve acetate, ethyl lactate, diethylene glycol dimethyl ether, butyl acetate, methyl 3-methoxypropionate, 2-heptanone, cyclohexanone, cyclopentanone, γ-butyrolactone, dimethyl sulfoxide, ethyl carbitol acetate, butyl carbitol acetate, propylene glycol methyl ether, and propylene glycol methyl ether acetate are preferable, cyclopentanone and γ-butyrolactone are more preferable, and cyclopentanone is even more preferable.

The developing time is preferably 10 seconds to 5 minutes. The temperature in the development is not particularly limited, and in general, the development can be performed at 20°C to 40°C.

Rinsing may be performed after the treatment using the developer. Rinsing is preferably performed with a solvent different from the developer. For example, rinsing can be performed with a solvent which is contained in the photosensitive resin composition. The rinsing time is preferably 5 seconds to 1 minute.

<Heating Step>

The method of manufacturing a semiconductor device according to the embodiment of the invention preferably includes a heating step. In the heating step, a cyclization reaction of the polyimide precursor, polybenzoxazole precursor, or the like proceeds. The polyimide, polybenzoxazole, or the like forms a three-dimensional network structure in a case where it is heated together with a crosslinking agent. Curing of the unreacted radical polymerizable compound also proceeds. The maximum heating temperature (maximum temperature during heating) is preferably 100°C to 500°C, more preferably 140°C to 400°C, and even more preferably 160°C to 350°C.

Heating is preferably performed from a temperature of 20°C to 150°C to the maximum heating temperature at a rate of temperature increase of 1 to 12°C/min, more preferably 2 to 10°C/min, and even more preferably 3 to 10°C/min. In a case where the rate of temperature increase is 2°C/min or greater, it is possible to prevent the amine from being excessively volatilized, while securing the productivity. In a case where the rate of temperature increase is 12°C/min or less, residual stress of the cured film can be relaxed.

The temperature at the start of heating is preferably 20°C to 150°C, more preferably 20°C to 130°C, and even more preferably 25°C to 120°C. The temperature at the start of heating refers to a heating temperature at the start of the step of performing heating to the maximum heating temperature. For example, in a case where the photosensitive resin composition is applied to the surface of the temporary adhesive film, and then dried, the temperature at the start of heating is a temperature after drying, and for example, the temperature is preferably gradually increased from a temperature 30°C to 200°C lower than the boiling point of the solvent contained in the photosensitive resin composition.

The heating is preferably performed for 10 to 400 minutes, and is more preferably performed for 20 to 380 minutes after the maximum heating temperature has been reached.

The heating may be performed in stages. For example, a pretreatment step may be performed involving increasing the temperature from 25°C to 180°C at a rate of 3°C/min, keeping at 180°C for 60 minutes, increasing the temperature from 180°C to 200°C at a rate of 2°C/min, and keeping at 200°C for 120 minutes. The heating temperature in the pretreatment step is preferably 100°C to 200°C, more preferably 110°C to 190°C, and even more preferably 120°C to 185°C. The pretreatment step is also preferably accompanied by ultraviolet irradiation as described in US9159547B. With such a pretreatment step, it is possible to improve the film characteristics. The pretreatment step preferably takes a short time of about 10 seconds to 2 hours, and more preferably 15 seconds to 30 minutes. The pretreatment step may be performed in two or more stages. For example, a pretreatment step 1 may be performed within a range of 100°C to 150°C, and then a pretreatment step 2 may be performed within a range of 150°C to 200°C.

Cooling may be performed after heating, and in this case, the cooling rate is preferably 1 to 5°C/min.

The heating step is preferably performed under an atmosphere with a low oxygen concentration by feeding an inert gas such as nitrogen, helium or argon from the viewpoint of inhibiting decomposition of the polyimide precursor and the like. The oxygen concentration is preferably 50 ppm (volume/volume) or less, and more preferably 20 ppm (volume/volume) or less.

<Step of Applying Metal>

The method of manufacturing a semiconductor device according to the embodiment of the invention includes a step of applying a metal between the resin patterns. Specifically, a metal is applied to grooves 5 removed by exposure and development of the resin film as shown in (2) in Fig. 2. Furthermore, as shown in (3) in Fig. 2, wires (metal) 6 may be applied to a part of the surface of the resin pattern 4.

The method of forming a metal is not particularly limited, and a known method can be applied. For example, a method described in JP2007-157879A, JP2001-521288A, JP2004-214501A, or JP2004-101850A can be used. For example, photolithography, lift-off, electrolytic plating, electroless plating, etching, printing, and combinations thereof are considered. More specific examples thereof include a patterning method based on a combination of sputtering, photolithography, and etching, and a patterning method based on a combination of photolithography and electrolytic plating.

As a patterning method based on a combination of sputtering, photolithography, and electrolytic plating, a method in which a seed layer is formed by sputtering, a pattern is formed by photolithography, and electrolytic plating is performed on the seed layer on which the pattern is formed is preferable.

The metal is preferably 0.1 to 50 μm thick, and more preferably 1 to 10 μm thick at the thickest portion thereof.

<Step of Alternately Repeating Step of Forming Resin Pattern and Step of Applying Metal>

The method of manufacturing a semiconductor device according to the embodiment of the invention preferably includes a step of alternately repeating the step of forming a resin pattern and the step of applying a metal. That is, as shown in (4) in Fig. 2, resin patterns 4 and wires (metal) 6 are repeatedly formed on the temporary adhesive film 2.

More specifically, the step of alternately repeating steps is a series of steps including performing the step of forming a photosensitive resin composition layer, the step of forming a resin pattern by exposing and developing the layer-like photosensitive resin composition, and the step of applying a metal in this order again. It is needless to say that the drying step, the heating step, and the like may be included.

The number of times of repetition is preferably 3 to 7 times, and more preferably 3 to 5 times. The larger the number of layers configured is, the more repeatedly the laminate is exposed to a high temperature treatment in the steps such as development, a metal etching treatment, and a curing step. Accordingly, peeling easily occurs at an interface between the metal and the resin pattern, or between the resin patterns.

That is, in the invention, particularly, a rewiring (RDL) structure can be formed by the step of alternately repeating the step of forming a resin pattern and the step of applying a metal.

<Step of Positioning Chip>

The method of manufacturing a semiconductor device according to the embodiment of the invention preferably further includes a step of positioning a chip so as to be in contact with the metal. In a case where a chip is provided so as to be in contact with the metal, the laminate can be utilized as a semiconductor device. The description in paragraphs 0185 to 0190 in WO2015/199219A and the description in Fig. 1 can be referred to for details of the semiconductor device, and the contents thereof are incorporated herein.

<Molding Processing Step>

The method of manufacturing a semiconductor device according to the embodiment of the invention may include a step of performing molding processing (molding) after the step of applying a metal and the step of positioning a chip. Molding processing is preferably performed on the side on which the metal or chip of the laminate is provided.

Regarding the mold material, for example, the description of a semiconductor sealing material described in JP2016-066726A and the description of a resin composition for semiconductor sealing described in WO2011/114687A can be referred to, and the contents thereof are incorporated herein. Regarding the molding processing method, the description in JP2016-066726A and the description in WO2011/114687A can be referred to, and the contents thereof are incorporated herein.

<Step of Separating Temporary Adhesive Film from Resin Pattern>

The method of manufacturing a semiconductor device according to the embodiment of the invention preferably includes a step of separating the temporary adhesive film after applying the resin pattern and the metal or after the molding processing step. In order to separate the temporary adhesive film, the temporary adhesive film may be peeled off or dissolved in a solvent. In the invention, the temporary adhesive film is preferably peeled off so as to be separated from the laminate. Here, the peeling of the temporary adhesive film refers separating the temporary adhesive film from the laminate by applying a physical action such as peeling by hand or peeling by machine, and is distinguished from separating the temporary adhesive film from the laminate by adding a chemical action such as dissolving in a solvent.

Specific examples of the separation method include a method including: peeling the support at an interface between the support and the temporary adhesive film; and thereafter peeling the temporary adhesive film from the laminate according to the embodiment of the invention, a method including: peeling the temporary adhesive film from

the laminate according to the embodiment of the invention at an interface between the temporary adhesive film and the resin pattern, a method including: peeling the support at an interface between the support and the temporary adhesive film; and thereafter dissolving the temporary adhesive film in a solvent to separate the temporary adhesive film from the laminate according to the embodiment of the invention, and a method including dissolving the temporary adhesive film in a solvent to separate the support from the laminate according to the embodiment of the invention.

In the invention, a method including: peeling the support at an interface between the support and the temporary adhesive film; and thereafter peeling the temporary adhesive film from the laminate according to the embodiment of the invention is particularly suitable.

The peeling method at an interface between the support and the temporary adhesive film is not particularly limited, and it is preferable that the mold is fixed, and the support is pulled up from an end portion thereof in a direction vertical to the resin film surface of the resin pattern and peeled off. In this case, the support is preferably peeled off at the interface between the support and the temporary adhesive film. The pulling speed at the time of peeling of the temporary adhesive film after peeling of the support is preferably 1 to 10 mm/min, and more preferably 1 to 4 mm/min.

The description in paragraphs 0165 to 0181 in WO2016/076261A can be referred to for details of the method of separating the temporary adhesive film, and the contents thereof are incorporated herein.

The method of manufacturing a semiconductor device according to the embodiment of the invention is not limited to the above-described embodiments, and can be appropriately modified or improved.

## Examples

Hereinafter, the invention will be more specifically described with examples. Materials, used amounts, ratios, treatment contents, treatment procedures, and the like shown in the following examples are able to be properly changed without departing from the intent of the invention. Therefore, the scope of the invention is not limited by the following specific examples. "Parts" and "%" are mass-based, unless otherwise specified.

### <Preparation of Composition for Temporary Adhesion>

Components shown in Table 1 were mixed to prepare a uniform solution, and then the solution was filtered using a filter having a pore size of 5.0 μm to prepare compositions for temporary adhesion A-1 to A-4.

[Table 1]

| | Elastomer | | Solvent | | Release Agent | | Antioxidant | |
|---|---|---|---|---|---|---|---|---|
| | Trade Name | Parts by Mass | Trade Name | Parts by Mass | Trade Name | Parts by Mass | Trade Name | Parts by Mass |
| A-1 | SEPTON 4033 | 100 | Mesitylene | 306 | TSF4445 | 0.038 | Irganox 1010/Sumilizer TP-D | 1/1 |
| A-2 | SEPTON 2104/SEPTON 4033 | 40/60 | Mesitylene | 306 | KP-323 | 0.8 | Irganox1010/Sumilizer TP-D | 1/1 |
| A-3 | SEPTON 4033 | 100 | Mesitylene | 306 | TSF4445 | 0.038 | - | - |
| A-4 | SEPTON 4033 | 100 | Mesitylene | 306 | - | - | Irganox1010/Sumilizer TP-D | 1/1 |

In the table, for example, the trade name "SEPTON 2104/SEPTON 4033" and the parts by mass "40/60" of A-2 mean that 40 parts by mass of SEPTON 2104 and 60 parts by mass of SEPTON 4033 are mixed. The same also applies to other components.

SEPTON 4033: manufactured by KURARAY CO., LTD., SEEPS
SEPTON 2104: manufactured by KURARAY CO., LTD., SEPS
TSF4445: manufactured by Momentive Performance Materials Inc., ratio represented by Formula (A) is 100%.
KP-323: manufactured by Shin-Etsu Chemical Co., Ltd., single material silicone
Irganox 1010: manufactured by BASF Japan Ltd.
Sumilizer TP-D: manufactured by Sumitomo Chemical Co., Ltd.

<Preparation of Photosensitive Resin Composition>

A surfactant shown below was mixed with LTC9320 E07 (photosensitive resin composition containing polyimide precursor, manufactured by FUJIFILM Corporation) in a proportion shown in Table 2 to prepare a uniform solution, and then the solution was filtered using a filter having a pore size of 0.8 μm to prepare photosensitive resin compositions B-1 to B-4. As B-5, LTC9320 E07 is used, and contains no surfactant.

[Table 2]

| | Photosensitive Resin Composition | Surfactant | Amount |
|---|---|---|---|
| B-1 | LTC9320 E07 | MEGAFACE F-569 | 1,000 mass ppm |
| B-2 | LTC9320 E07 | MEGAFACE F-569 | 500 mass ppm |
| B-3 | LTC9320 E07 | MEGAFACE F-410 | 1,000 mass ppm |
| B-4 | LTC9320 E07 | MEGAFACE F-444 | 1,000 mass ppm |
| B-5 | LTC9320 E07 | - | |

In the table, the amount refers to the mass ratio of the surfactant to the resin.
MEGAFACE F-569: fluorine-based surfactant, manufactured by DIC Corporation
MEGAFACE F-410: fluorine-based surfactant, manufactured by DIC Corporation
MEGAFACE F-444: fluorine-based surfactant, manufactured by DIC Corporation

<Formation of Laminate (Examples 1 to 9 and Comparative Examples 1 to 3)>

<<Temporary Adhesive Film Forming Step>>

A silicon wafer having a diameter of 12 inches (1 inch = 2.54 cm) was used as a support, and on a surface thereof, a composition for temporary adhesion described in Table 1 was formed as a film by a wafer bonding device (Synapse V, manufactured by Tokyo Electron Limited). The film was heated at 130°C for 3 minutes using a hot plate, and further heated at 190°C for 3 minutes to form a temporary adhesive film on the surface of the support. In this case, the thickness of the temporary adhesive film was 60 μm.

<<Resin Pattern Forming Step>>

Next, a photosensitive resin composition was applied to a surface of the temporary adhesive film in the form of a layer by a spin coating method to form a photosensitive resin composition layer.
The obtained photosensitive resin composition layer was dried at 100°C for 5 minutes using a hot plate to obtain a uniform photosensitive resin film having a thickness of 15 μm.
The obtained laminate including the support, the temporary adhesive film, and the photosensitive resin film is defined as a laminate A. As will be described later, surface state evaluation was performed on the laminate A.
Next, the photosensitive resin film of the laminate A was covered by a line mask having a width of 10 μm, and irradiated with light having a wavelength of 365 nm (i-ray) with an exposure energy of 500 $mJ/cm^2$ using a stepper (Nikon NSR 2005 i9C) (pattern exposure).
The exposed resin film was dipped in cyclopentanone at 30°C for 60 seconds and developed to obtain a resin pattern. The obtained laminate including the support, the temporary adhesive film, and the resin pattern is defined as a laminate B.

<<Curing Step>>

The resin pattern of the obtained laminate B was cured through the following steps (1) to (4).

(1) Temperature Increasing Step

First, under a nitrogen atmosphere with an oxygen concentration of 20 vol. ppm or less, the laminate B was placed on a temperature-adjustable plate. The temperature was increased from room temperature (20°C) at a rate of temperature increase of 10°C/min, and the laminate B was heated to a final reaching temperature of 230°C for 21 minutes.

(2) Keeping Step

Then, the laminate B was kept for 3 hours at 230°C that was the final reaching temperature of the temperature increasing step.

(3) Cooling Step

The laminate B after the heating for 3 hours in the keeping step was slowly cooled to 170°C, that was a final reaching temperature of the cooling step, from 230°C for 30 minutes at a rate of temperature decrease of 2°C/min.

(4) Step of Adjusting Temperature to Room Temperature

After the laminate B reached 170°C that was the final reaching temperature of the cooling step, the laminate B was cooled at a rate of temperature decrease of 5 to 10°C/min to reach room temperature, whereby the resin pattern is cured.

<<Metal Layer Forming Step>>

Next, in a sputtering device (product name: Endura, manufactured by Applied Materials, Inc.), Ti was deposited with a thickness of 100 nm using a sputtering method under the condition where the temperature of the laminate B was 150°C, thereby forming a first metal layer to be used as a barrier metal film between the resin patterns of the laminate B after the curing step and on the surfaces of the resin patterns. Next, Cu was deposited with a thickness of 300 nm, thereby forming a second metal layer to be used as a seed layer. The total thickness of the metal layer thus formed was 400 nm.

Next, a dry film resist (trade name: Photec RY-3525, manufactured by Hitachi Chemical Co., Ltd.) was adhered on the seed layer by a roll laminator, and was brought into close contact with a phototool having a pattern formed therein. Exposure was performed thereon with an energy amount of 100 $mJ/cm^2$ using an exposure machine EXM-1201 manufactured by ORC MANUFACTURING CO., LTD. Next, spray development was performed at 30°C for 90 seconds using a 1 mass% sodium carbonate aqueous solution to open the dry film resist. Next, using an electrolytic copper plating method, a copper plating layer having a thickness of 7 μm was formed on the dry film resist and on the seed layer at the portion where the dry film resist was opened. Next, the dry film resist was peeled off using a peeling solution. Next, the seed layer (300 nm Cu layer) of the portion from which the dry film resist was peeled off was removed using an etching solution to form a patterned metal layer on the surface of the resin pattern after the curing step.

<<Repetition of Processing>>

The resin pattern forming step and the curing step were performed again using the same photosensitive resin composition on the metal layer and on the surface having irregularities formed thereon due to the resin pattern after the curing, and thus a laminate C having two resin pattern layers after the curing was formed.

The metal layer forming step was performed again in the same manner on the laminate C having two resin pattern layers after the curing, and thus a laminate D was formed.

<Surface State Evaluation 1>

The interface between the temporary adhesive film and the photosensitive resin film of the laminate A was observed with an optical microscope to perform surface state evaluation according to the following criteria.

A: No bubbles were confirmed.
B: Bubbles were confirmed in a part of the interface.
C: A large number of bubbles were confirmed. Or, the photosensitive resin film or the photosensitive resin composition was repelled.

<Surface State Evaluation 2>

The laminate A was cut in a thickness direction of the temporary adhesive film and the photosensitive resin film, and the interface was observed with an electron microscope to perform surface state evaluation according to the following criteria.

A: The interface is a mirror surface having no irregularities by dissolving or swelling
B: The interface is a mirror surface having irregularities by dissolving or swelling in a part thereof.
C: The interface has many irregularities by dissolving or swelling, and is thus not a mirror surface.

<Peeling Evaluation>

A resin composition for semiconductor sealing was prepared according to a method described in Example 1 in WO2011/114687A. Next, a surface of the obtained laminate D on the side on which the metal layer was provided was mold-processed by injecting the resin composition for semiconductor sealing using a low pressure transfer molding machine (GP-ELF, manufactured by DAI-ICHI SEIKO CO., LTD.) under the conditions of a mold temperature of 180°C and an injection pressure of 6.9±0.17 MPa for 10 minutes.
Next, using a dicing tape mounter, the molded side of the mold-processed laminate D was fixed to the center of a dicing tape together with a dicing frame. Thereafter, using a wafer debonder device (Synapse Z, manufactured by Tokyo Electron Limited), the mold-processed side was fixed to the lower side at 25°C, and the support of the laminate D was peeled off in a direction vertical to the film surface of the laminate D. Then, the temporary adhesive film present in the upper portion of the laminate was pulled up in the vertical direction at a speed of 3 mm/min in the same manner to confirm whether the laminate can be peeled off without being broken, and the evaluation was performed according to the following criteria.

A: Peeling was possible.
B: Although the temporary adhesive film partially floated from the interface of the resin pattern, peeling was possible.
D: Peeling was impossible.

<O/C Ratio>

Element analysis was performed with regard to the temporary adhesive film forming component in the composition for temporary adhesion and the resin pattern forming component in the photosensitive resin composition. A mass ratio O/C between an oxygen atom and a carbon atom was calculated based on the obtained values.

[Table 3]

| | Temporary Adhesive Film | | Photosensitive Resin Composition | | Surface State Evaluation 1 | Surface State Evaluation 2 | Peeling Evaluation |
|---|---|---|---|---|---|---|---|
| | Type | O/C Ratio | Type | O/C Ratio | | | |
| Example 1 | A-1 | 0.01 | B-1 | 0.31 | A | A | A |
| Example 2 | A-1 | 0.01 | B-2 | 0.30 | B | B | A |
| Example 3 | A-2 | 0.01 | B-1 | 0.31 | A | B | B |
| Example 4 | A-2 | 0.01 | B-2 | 0.30 | B | B | B |
| Example 5 | A-3 | 0.01 | B-1 | 0.31 | A | B | A |
| Example 6 | A-3 | 0.01 | B-2 | 0.30 | B | B | A |
| Example 7 | A-4 | 0.01 | B-1 | 0.31 | B | B | C |
| Example 8 | A-1 | 0.01 | B-3 | 0.30 | A | A | A |
| Example 9 | A-1 | 0.01 | B-4 | 0.30 | A | A | A |
| Comparative Example 1 | A-1 | 0.01 | B-5 | 0.29 | C | C | A |
| Comparative Example 2 | A-2 | 0.01 | B-5 | 0.29 | C | C | B |
| Comparative Example 3 | A-4 | 0.01 | B-5 | 0.29 | C | C | D |

As is obvious from the results, in a case where the resin pattern or the photosensitive resin composition contained

a surfactant, the surface state at an interface between the temporary adhesive film and the photosensitive resin film was excellent, and it was possible to separate the temporary adhesive film from the resin pattern.

Explanation of References

1: support

2: temporary adhesive film

3: chip

4: resin film or resin pattern

5: groove

6: wire

## Claims

**1.** A laminate comprising:

- a temporary adhesive film (2);
- positioned on a surface of the temporary adhesive film, a resin pattern (4) which contains a surfactant; the resin pattern being a developed layer-like photosensitive resin composition; and
- a metal (6) which is positioned at least between the resin patterns; wherein an oxygen atom/carbon atom mass ratio, O/C, is 0.20-0.40 in the resin pattern and is 0-0.05 in the temporary adhesive film.

**2.** The laminate of claim 1, wherein the temporary adhesive film contains

- at least one of a thermoplastic resin, a thermosetting resin, or a photocurable resin; or
- a styrene-based resin.

**3.** The laminate of claim 1 or 2, wherein the resin pattern contains a polyimide resin.

**4.** The laminate of any of claims 1-3, wherein the temporary adhesive film contains a release agent.

**5.** The laminate of any of claims 1-4, wherein the resin pattern contains a surfactant in a proportion of $> 0$ to $\leq 1.0$ mass-% of the resin pattern.

**6.** The laminate of any of claims 1-5, wherein the metal is copper.

**7.** The laminate of any of claims 1-6, wherein the temporary adhesive film is positioned on a support.

**8.** The laminate of any of claims 1-7, further comprising a chip which is in contact with the metal.

**9.** The laminate of any of claims 1-8, wherein the temporary adhesive film contains a release agent containing a silicon atom, and the resin pattern contains a fluorine-based surfactant.

**10.** A method of manufacturing a laminate comprising the steps of

(i) applying a photosensitive resin composition containing a resin and a surfactant to a surface of a temporary adhesive film (2) in the form of a layer;
(ii) forming a resin pattern (4) by exposing and developing the layer-like photosensitive resin composition; and
(iii) applying a metal (6) at least between the resin patterns; wherein an oxygen atom/carbon atom mass ratio, O/C, is 0.20-0.40 in the resin pattern and is 0-0.05 in the temporary adhesive film.

**11.** The method of claim 10, further comprising the step(s) of

- positioning a chip so as to be in contact with the metal; and/or
- separating the temporary adhesive film from the resin pattern.

**12.** The method of claim 10 or 11, further comprising alternately repeating the steps (ii) and (iii) a plurality of times.

**13.** The method of any of claims 10-12, wherein in step (ii) a developer is used, which developer contains

- a solvent in which a solubility of the temporary adhesive film at 25°C is ≤ 1 mass-%; or
- cyclopentanone.

**14.** The method of any of claims 10-13, further comprising forming the temporary adhesive film using a composition for temporary adhesion containing at least one of a thermoplastic resin, a thermosetting resin, or a photocurable resin.

**Patentansprüche**

**1.** Laminat, umfassend;

- eine temporär klebende Folie (2);
- eine auf einer Oberfläche der temporär klebenden Folie angeordnete Harzstruktur (4), die ein Tensid enthält; wobei die Harzstruktur eine entwickelte schichtartige lichtempfindliche Harzzusammensetzung ist; und
- ein Metall (6), das mindestens zwischen den Harzstrukturen angeordnet ist;

worin ein Massenverhältnis von Sauerstoffatom/Kohlenstoffatom, O/C, 0,20-0,40 in der Harzstruktur beträgt und 0-0,05 in der temporär klebenden Folie beträgt.

**2.** Laminat gemäß Anspruch 1, worin die temporär klebende Folie

- mindestens eines aus einem thermoplastischen Harz, einem wärmehärtbaren Harz oder einem lichthärtbaren Harz; oder
- ein Harz auf Styrolbasis enthält.

**3.** Laminat gemäß Anspruch 1 oder 2, worin die Harzstruktur ein Polyimidharz enthält.

**4.** Laminat gemäß mindestens einem der Ansprüche 1-3, worin die temporär klebende Folie ein Trennmittel enthält.

**5.** Laminat gemäß mindestens einem der Ansprüche 1-4, worin die Harzstruktur ein Tensid in einem Anteil von > 0 bis ≤ 1,0 Massen-% der Harzstruktur enthält.

**6.** Laminat gemäß mindestens einem der Ansprüche 1-5, worin das Metall Kupfer ist.

**7.** Laminat gemäß mindestens einem der Ansprüche 1-6, worin die temporär klebende Folie auf einem Träger angeordnet ist.

**8.** Laminat gemäß mindestens einem der Ansprüche 1-7, ferner umfassend einen Chip, der sich in Kontakt mit dem Metall befindet.

**9.** Laminat gemäß mindestens einem der Ansprüche 1-8, worin die temporär klebende Folie ein Trennmittel enthält, das ein Siliciumatom enthält, und die Harzstruktur ein Tensid auf Fluorbasis enthält.

**10.** Verfahren zur Herstellung eines Laminats, umfassend die Schritte

(i) des Aufbringens einer lichtempfindlichen Harzzusammensetzung, die ein Harz und ein Tensid enthält, auf eine Oberfläche einer temporär klebenden Folie (2) in Form einer Schicht;
(ii) des Ausbildens einer Harzstruktur (4), indem die schichtartige lichtempfindliche Harzzusammensetzung belichtet und entwickelt wird; und
(iii) des Aufbringens eines Metalls (6) mindestens zwischen den Harzstrukturen;

worin ein Massenverhältnis von Sauerstoffatom/Kohlenstoffatom, O/C, 0,20-0,40 in der Harzstruktur beträgt und 0-0,05 in der temporär klebenden Folie beträgt.

**11.** Verfahren gemäß Anspruch 10, ferner umfassend den Schritt/die Schritte

- des Anordnens eines Chips, so dass sich dieser in Kontakt mit dem Metall befindet; und/oder
- des Trennens der temporär klebenden Folie von dem Harzmuster.

**12.** Verfahren gemäß Anspruch 10 oder 11, ferner umfassend das mehrfache abwechselnde Wiederholen der Schritte (ii) und (iii).

**13.** Verfahren gemäß mindestens einem der Ansprüche 10-12, worin in Schritt (ii) ein Entwicklungsmittel verwendet wird, das

- ein Lösungsmittel, in dem die Löslichkeit der temporär klebenden Folie bei 25°C ≤ 1 Massen-% beträgt; oder
- Cyclopentanon enthält.

**14.** Verfahren gemäß mindestens einem der Ansprüche 10-13, ferner umfassend das Bilden einer temporär klebenden Folie unter Verwendung einer Zusammensetzung für temporäre Haftung, die mindestens eines aus einem thermoplastischen Harz, einem wärmehärtbaren Harz oder einem lichthärtbaren Harz enthält.

**Revendications**

**1.** Stratifié comprenant :

- un film adhésif temporaire (2) ;
- positionné sur une surface du film adhésif temporaire, un motif de résine (4) qui contient un tensioactif; le motif de résine étant une composition de résine photosensible de type couche développée ; et
- un métal (6) qui est positionné au moins entre les motifs de résine ;

dans lequel un rapport massique atome d'oxygène/atome de carbone, O/C, est de 0,20 à 0,40 dans le motif de résine et est de 0 à 0,05 dans le film adhésif temporaire.

**2.** Stratifié selon la revendication 1, dans lequel le film adhésif temporaire contient

- au moins l'une d'une résine thermoplastique, d'une résine thermodurcissable ou d'une résine photodurcissable ; ou
- une résine à base de styrène.

**3.** Stratifié selon la revendication 1 ou 2, dans lequel le motif de résine contient une résine polyimide.

**4.** Stratifié selon l'une quelconque des revendications 1 à 3, dans lequel le film adhésif temporaire contient un agent anti-adhérent.

**5.** Stratifié selon l'une quelconque des revendications 1 à 4, dans lequel le motif de résine contient un tensioactif en une proportion de > 0 à ≤ 1,0 % en masse du motif de résine.

**6.** Stratifié selon l'une quelconque des revendications 1 à 5, dans lequel le métal est du cuivre.

**7.** Stratifié selon l'une quelconque des revendications 1 à 6, dans lequel le film adhésif temporaire est positionné sur un support.

**8.** Stratifié selon l'une quelconque des revendications 1 à 7, comprenant en outre une puce qui est en contact avec le métal.

**9.** Stratifié selon l'une quelconque des revendications 1 à 8, dans lequel le film adhésif temporaire contient un agent anti-adhérent contenant un atome de silicium, et le motif de résine contient un tensioactif à base de fluor.

**10.** Procédé de fabrication d'un stratifié comprenant les étapes suivantes :

(i) application d'une composition de résine photosensible contenant une résine et un tensioactif sur une surface d'un film adhésif temporaire (2) sous la forme d'une couche ;
(ii) formation d'un motif de résine (4) par exposition et développement de la composition de résine photosensible de type couche ; et
(iii) application d'un métal (6) au moins entre les motifs de résine ;
dans lequel un rapport massique atome d'oxygène/atome de carbone, O/C, est de 0,20 à 0,40 dans le motif de résine et est de 0 à 0,05 dans le film adhésif temporaire.

**11.** Procédé selon la revendication 10, comprenant en outre la (les) étape(s) de

- positionnement d'une puce de façon à ce qu'elle soit en contact avec le métal ; et/ou
- séparation du film adhésif temporaire du motif de résine.

**12.** Procédé selon la revendication 10 ou 11, comprenant en outre la répétition alternée des étapes (ii) et (iii) une pluralité de fois.

**13.** Procédé selon l'une quelconque des revendications 10 à 12, dans lequel dans l'étape (ii) un agent de développement est utilisé, lequel agent de développement contient

- un solvant dans lequel une solubilité du film adhésif temporaire à 25 °C est $\leq$ 1 % en masse ; ou
- de la cyclopentanone.

**14.** Procédé selon l'une quelconque des revendications 10 à 13, comprenant en outre la formation du film adhésif temporaire en utilisant une composition pour adhérence temporaire contenant au moins l'une d'une résine thermoplastique, d'une résine thermodurcissable ou d'une résine photodurcissable.

FIG. 1

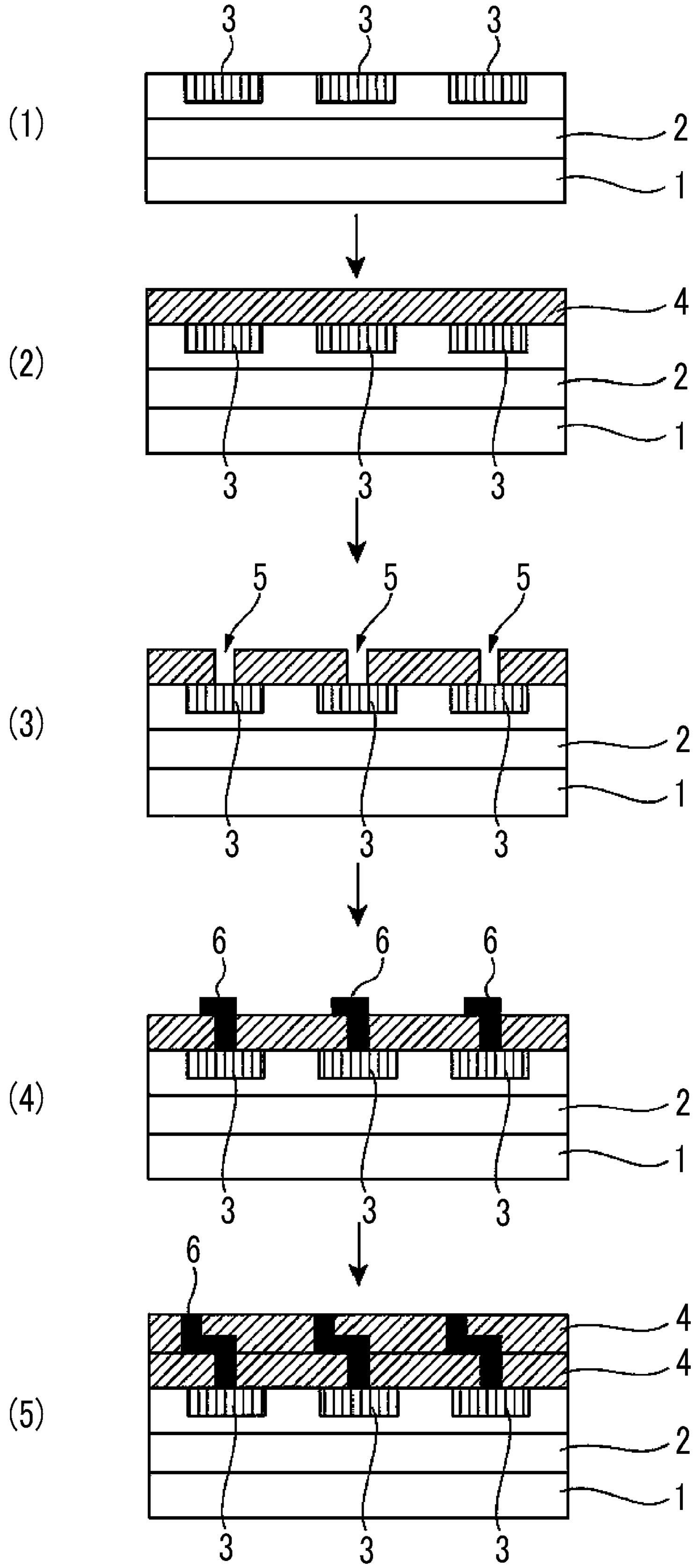

FIG. 2

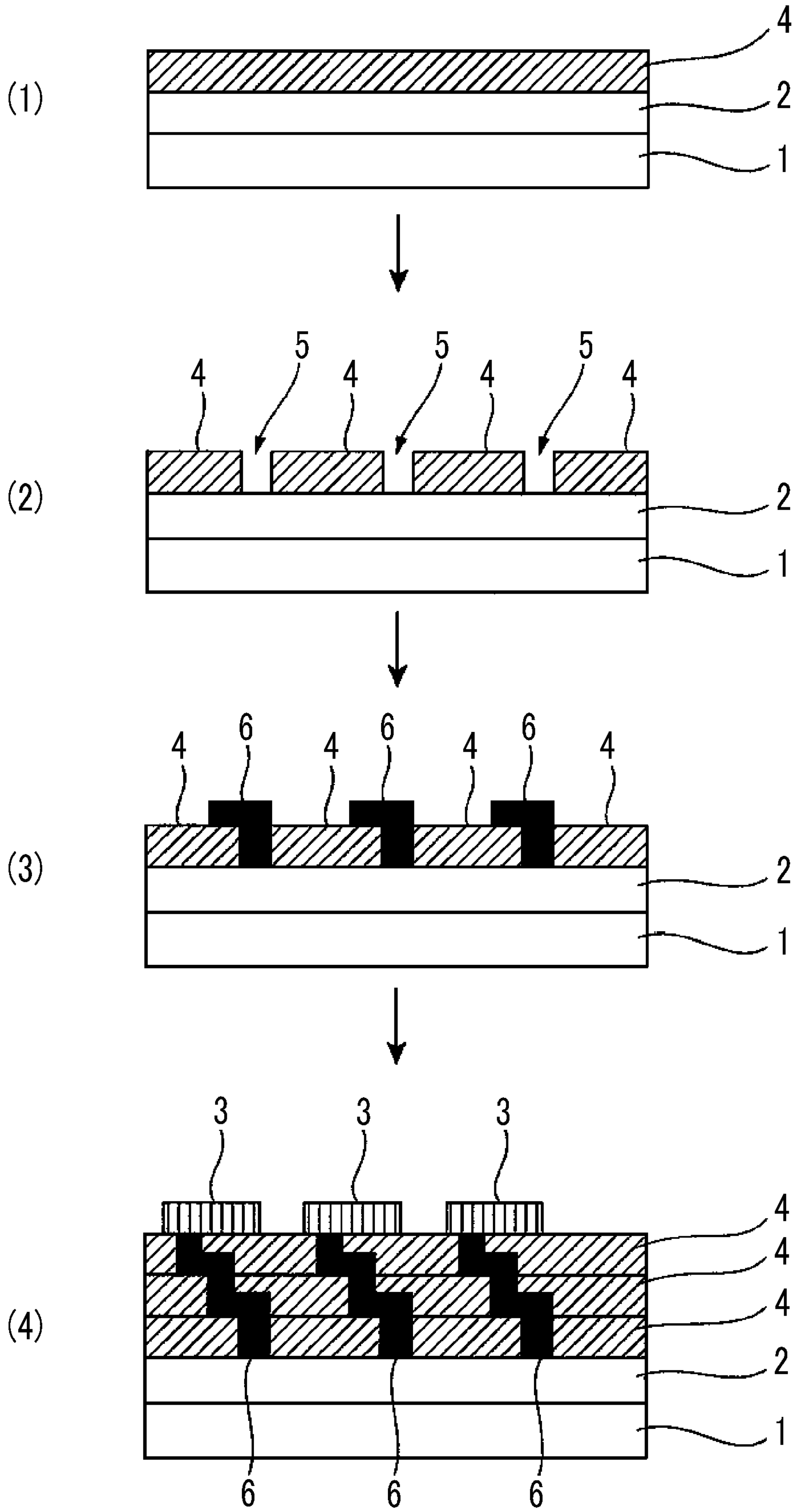

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2015165015 A
- JP 2016086158 A
- WO 2015190477 A
- JP 62036663 A
- JP S62036663 A
- JP 61226746 A
- JP S61226746 A
- JP 61226745 A
- JP S61226745 A
- JP 62170950 A
- JP S62170950 A
- JP 63034540 A
- JP S63034540 A
- JP 7230165 A
- JP H07230165 A
- JP 8062834 A
- JP H08062834 A
- JP 9054432 A
- JP H09054432 A
- JP 9005988 A
- JP H09005988 B
- JP 2001330953 A
- JP 2016027357 A
- JP 2015036774 A
- WO 2015199219 A
- WO 2014045434 A
- JP 2001233842 A
- JP 2000080068 A
- JP 2006342166 A
- JP 2000066385 A
- JP 2004534797 A
- WO 2015036910 A
- JP 2012014052 A
- JP 2009242469 A
- JP 2010262028 A
- JP 2014500852 A
- JP 2013164471 A
- JP 2011089090 A
- JP 2008203359 A
- JP 2008276166 A
- JP 2009047927 A
- US 9159547 B
- JP 2007157879 A
- JP 2001521288 A
- JP 2004214501 A
- JP 2004101850 A
- JP 2016066726 A
- WO 2011114687 A
- WO 2016076261 A


### Non-patent literature cited in the description


- *J. C. S. Perkin II,* 1979, 1653-1660
- *J. C. S. Perkin II,* 1979, 156-162
- *Journal of Photopolymer Science and Technology,* 1995, 202-232